(19) Europäisches Patentamt / European Patent Office / Office européen des brevets

(11) **EP 4 485 343 A1**

(12) **EUROPEAN PATENT APPLICATION**

(43) Date of publication:
**01.01.2025   Bulletin 2025/01**

(21) Application number: **24184973.6**

(22) Date of filing: **27.06.2024**

(51) International Patent Classification (IPC):
**G06T 1/20** (2006.01)

(52) Cooperative Patent Classification (CPC):
**G06T 1/20; G06N 3/06; G06N 3/08**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.06.2023   GB 202310033**
**30.06.2023   GB 202310032**
**30.06.2023   GB 202310035**

(71) Applicant: **Imagination Technologies Limited Kings Langley, Hertfordshire WD4 8LZ (GB)**

(72) Inventor: **Imber, James**
**Kings Langley, WD4 8LZ (GB)**

(74) Representative: **Slingsby Partners LLP**
**1 Kingsway**
**London WC2B 6AN (GB)**

(54) **IMAGE SIGNAL PROCESSING**

(57)    This disclosure provides a differentiable module of a differentiable model of an image signal processor, the image signal processor comprising a pipeline of functional blocks, wherein the differentiable module is configured to implement a single functional block of the pipeline, the differentiable module comprising: base logic configured to receive an input image signal and to process the received input image signal by performing a base image processing function that represents a task of the functional block of the pipeline implemented by the module; a refinement function configured to receive the input image signal and to process the received input image signal in parallel to the processing of the received input image signal by the base logic; and combining logic configured to combine the processed image signal from the base logic and the processed image signal from the refinement function to determine an output image signal to be outputted from the differentiable module. This disclosure also provides a corresponding method.

Figure 3

EP 4 485 343 A1

**Description**

CROSS-REFERENCE TO RELATED APPLICATIONS

This application claims priority from UK patent application GB2310032.4 filed on 30 June 2023, UK patent application GB2310035.7 filed on 30 June 2023, and UK patent application GB2310033.2 filed on 30 June 2023, which are herein incorporated by reference in their entirety.

TECHNICAL FIELD

The present disclosure relates to image signal processing, e.g. on an inference device such as a neural network accelerator.

BACKGROUND

Image signal processing, which can be performed by an image signal processor (hereafter referred to as an ISP), is a process of modifying raw image data representing images captured by a camera. An ISP may be specialised to produce images for consumption by a human user. Alternatively, an ISP may be specialised for processing images for consumption by computer vision algorithms, or it may output multiple images for various computer vision algorithms and/or human viewing. The processing of the raw images will generally involve performing a number of tasks such as denoising, demosaicing, sharpening and colour correcting an image, however this list is non-exhaustive. An ISP (or particular image processing functions performed by the ISP) can be considered in terms of inverting the image capture process (or inverting corresponding particular aspects of the image capture process) performed by a camera. In some cases, an ISP may not fully invert an image capture process. For example, when used for computer vision algorithm inputs, colour correction is not usually necessary and thus the ISP pipeline may omit this image processing function.
ISPs are most commonly implemented as dedicated silicon hardware, using a streaming (typically linestore-based) architecture comprising a pipeline of well-defined, hand-engineered, fixed-function modules. Each module may be configured in hardware for performing a particular image processing function, e.g. denoising, demosaicing, sharpening, colour correction, etc. These image processing functions may be thought of as tasks performed by the ISP. However, engineering ISPs that implement a pipeline of well-defined, hand-engineered, fixed-function modules as the modules of the ISP leads to two significant hidden costs. The first cost comes with the process of tuning the parameters that govern the behaviour of individual modules. This tuning is a laborious and time-consuming process that is usually performed manually or semi-manually. The second cost is in the process of engineering modules for implementation in fixed function hardware, which makes it expensive to develop, debug and make changes due to (i) the complexity of having to consider hardware implementation during algorithm design; (ii) the need to tune the algorithm during development to evaluate quality; (iii) the cost of (re-) implementing in e.g. a hardware description language; and (iv) the need to (re-) verify the hardware design.
WO 2022193514 A1 discloses end to end differentiable machine vision systems, training methods, and processor-readable media. A differentiable image signal processor (ISP) can be trained, using machine learning techniques, to adapt raw images received from a new sensor into adapted images of the same type (i.e. in the same visual domain) as the images previously used to train a perception module, without fine-tuning the perception module itself.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.
According to a first aspect of this disclosure there is provided a differentiable module of a differentiable model of an image signal processor, the image signal processor comprising a pipeline of functional blocks, wherein the differentiable module is configured to implement a single functional block of the pipeline, the differentiable module comprising: base logic configured to receive an input image signal and to process the received input image signal by performing a base image processing function that represents a task of the functional block of the pipeline implemented by the module; a refinement function configured to receive the input image signal and to process the received input image signal in parallel to the processing of the received input image signal by the base logic; and combining logic configured to combine the processed image signal from the base logic and the processed image signal from the refinement function to determine an output image signal to be outputted from the differentiable module.
The differentiable module described above wherein the differentiable module may be representable with a command stream as a combination of operations from a set of elementary neural network operations which are available on an inference device, for implementation on the inference device.

The differentiable module described above wherein the set of elementary neural network operations may consist of one or more of: a convolutional operation; a pooling operation; an element-wise operation; an activation operation; a local response normalisation operation; a tensor rescale operation; a channel permutation operation; and a reshaping operation.

The differentiable module described above wherein the inference device may be a neural network accelerator.

The differentiable module described above wherein the base image processing function that the logic of the differentiable module may be configured to perform may be a function that, when applied to an image signal, refines the image signal in one regard.

The differentiable module described above, wherein the refinement function may be configured to supplement the refinement performed by the base image processing function.

The differentiable module described above, wherein in supplementing the refinement performed by the base image processing function the refinement function may be configured to process the input image signal in a manner such that the combining logic corrects an error remaining in the processed image signal after the base logic has processed the received input image signal.

The differentiable module described above, wherein a refinement of the image signal that may be performed by the refinement function may be small in comparison to a refinement of the image signal performed by the base logic.

The differentiable module described above, wherein the differentiable module may be any of a demosaicing module, a sharpener module, a black-level subtraction module, a spatial denoiser module, a global tone mapping module, a channel gain module, an automatic white balance, or a colour correction module.

A further aspect provided by this disclosure may be an inference device for image processing, the inference device configured to implement a command stream may represent a differentiable model of an image signal processor which comprises the differentiable module described above.

According to a further aspect of this disclosure there is provided a method of processing an image signal using an inference device which is configured to implement a command stream representing a differentiable model of an image signal processor, the image signal processor having a pipeline of functional blocks, wherein the model of the image signal processor comprises a differentiable module configured to implement a single functional block of the pipeline, the method comprising: receiving an input image signal at the differentiable module; processing the received input image signal by performing a base image processing function that represents a task of the functional block of the pipeline implemented by the module; processing the received input image signal using a refinement in parallel to said processing the received input image signal by performing a base image processing function; combining the processed image signal from performing the base image processing function and the processed image signal from using the refinement function to determine an output image signal; and outputting the determined output image signal from the differentiable module.

The method described above wherein the command stream may represent the differentiable model of the image signal processor as a combination of operations from a set of elementary neural network operations which are available on the inference device.

The method described above wherein the set of elementary neural network operations may consist of one or more of: a convolutional operation; a pooling operation; an element-wise operation; an activation operation; a local response normalisation operation; a tensor rescale operation; a channel permutation operation; a reshaping operation; a concatenation; reduction operations including sum, mean, minimise and maximise.

The method described above wherein the inference device may be a neural network accelerator.

The method described above wherein said processing the received input image signal by performing the base image processing function may refine the received input image signal in one regard.

The method according described above, wherein said processing the received input image signal using the refinement function may supplement the refinement performed by the base image processing function.

The method according described above, wherein said processing the received input image signal using the refinement function may supplement the refinement performed by the base image processing function such that said combining corrects an error in the processed image signal from performing the base image processing function.

The method described above, wherein a refinement of the image signal that may be performed by processing the received input image signal using the refinement function may be small in comparison to a refinement of the image signal performed by processing the received input image signal by performing the base image processing function.

The method described above, wherein the task of the functional block of the pipeline implemented by the module may be any of demosaicing, sharpening, black-level subtraction, spatial denoising, global tone mapping, channel gain application, automatic white balance, or colour correction.

The method described above wherein the inference device may be embodied in hardware on an integrated circuit.

There may be provided a computer readable code configured to cause the method described above to be performed when the code is run.

There may be provided an integrated circuit definition dataset that, when processed in an integrated circuit manufacturing system, may configure the integrated circuit manufacturing system to manufacture an inference device as described above.

There may be provided a training apparatus for training a differentiable model of an image signal processor, the image signal processor having a pipeline of separate image signal processing functions, wherein the differentiable model of the image signal processor comprises at least two differentiable modules, each of the differentiable modules of the differentiable model of the image signal processor being configured to perform a respective single image signal processing function of the pipeline, the training apparatus comprising one or more processors configured to: receive a reference image; and train a first differentiable module of the differentiable model of the image signal processor to perform a first image signal processing function, whilst not training other differentiable modules of the differentiable model of the image signal processor, by iteratively: inputting, to the differentiable model of the image signal processor, a degraded image signal that represents a known degradation of the reference image, the degradation being related to the first image signal processing function; processing the degraded image signal using the differentiable model of the image signal processor to produce a first processed image, said processing including using the first differentiable module to perform the first image signal processing function; calculating an error between the first processed image and the reference image by comparing the first processed image to the reference image; and updating the first image processing function performed by the first differentiable module based on the calculated error without updating the image processing functions performed by other differentiable modules of the differentiable model of the image signal processor.

There may be provided a training method for training a differentiable model of an image signal processor, the image signal processor having a pipeline of separate image signal processing functions, wherein the differentiable model of the image signal processor comprises at least two differentiable modules, each of the differentiable modules of the differentiable model of the image signal processor being configured to perform a respective single image signal processing function of the pipeline, the training method comprising: receiving a reference image; and training a first differentiable module of the differentiable model of the image signal processor to perform a first image signal processing function, whilst not training other differentiable modules of the differentiable model of the image signal processor, by iteratively: inputting, to the differentiable model of the image signal processor, a degraded image signal that represents a known degradation of the reference image, the degradation being related to the first image signal processing function; processing the degraded image signal using the differentiable model of the image signal processor to produce a first processed image, said processing including using the first differentiable module to perform the first image signal processing function; calculating an error between the first processed image and the reference image by comparing the first processed image to the reference image; and updating the first image processing function performed by the first differentiable module based on the calculated error without updating the image processing functions performed by other differentiable modules of the differentiable model of the image signal processor.

There may be provided an inference device configured to implement a command stream representing a differentiable model of an image signal processor as a combination of operations from a set of elementary neural network operations which are available on the inference device, the image signal processor having a pipeline of two or more functional blocks, the differentiable model of the image signal processor comprising: at least two differentiable modules, each of the at least two differentiable modules configured to implement a respective single functional block of the pipeline.

There may also be provided a method of processing an image signal using an inference device which is configured to implement a command stream representing a differentiable model of an image signal processor as a combination of operations from a set of elementary neural network operations which are available on the inference device, the differentiable model of the image signal processor having a pipeline of two or more functional blocks, the method comprising: processing the image signal using the inference device in a manner corresponding to processing by a first differentiable module of the model of the image signal processor to produce a first processed image signal, wherein the first differentiable module of the model of the image signal processor is configured to implement a first functional block of the pipeline; and processing the first processed image signal using the inference device in a manner representing processing by a second differentiable module of the model of the image signal processor to produce a second processed image signal, wherein the second differentiable module of the model of the image signal processor is configured to implement a second functional block of the pipeline, wherein each of the first and second differentiable modules of the model of the image signal processor is configured to implement a respective single functional block of the pipeline.

The inference device, neural network accelerator (NNA) or training apparatus may be embodied in hardware on an integrated circuit. There may be provided a method of manufacturing, at an integrated circuit manufacturing system, an inference device, an NNA or training apparatus. There may be provided an integrated circuit definition dataset that, when processed in an integrated circuit manufacturing system, configures the system to manufacture an inference device, an NNA or training apparatus. There may be provided a non-transitory computer readable storage medium having stored thereon a computer readable description of an inference device, an NNA or a training apparatus that, when processed in an integrated circuit manufacturing system, causes the integrated circuit manufacturing system to manufacture an integrated circuit embodying an inference device, an NNA or a training apparatus.

There may be provided an integrated circuit manufacturing system comprising: a non-transitory computer readable storage medium having stored thereon a computer readable description of the inference device, the NNA or the training apparatus; a layout processing system configured to process the computer readable description so as to generate a circuit layout description of an integrated circuit embodying the inference device, the NNA or the training apparatus; and an integrated circuit generation system configured to manufacture the inference device, the NNA or the training apparatus according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

BRIEF DESCRIPTION OF THE DRAWINGS

Examples will now be described in detail with reference to the accompanying drawings in which:

Figure 1 shows a general image capture and inversion process that may be used for training the ISP;
Figure 2 illustrates an example overview of a general image capture process and ISP pipeline designed to invert the image capture process;
Figure 3 illustrates a general training and testing method of the present disclosure, including camera characterisation;
Figure 4 illustrates a general training method of the present disclosure;
Figure 5 illustrates an example structure of an ISP demosaicing module of this disclosure within an illustration of an ISP demosaicing module training process;
Figure 6 illustrates an example of an ISP denoising module of this disclosure within an illustration of an ISP denoising module training process;
Figure 7 shows an example of an ISP sharpening module within an illustration of a sharpening module training process;
Figure 8 shows an example of a computational graph of a modular ISP pipeline that may be implemented on an NNA of this disclosure;
Figure 9 shows a further example of a modular ISP pipeline that may be implemented on an NNA of this disclosure;
Figure 10 shows a plot of the variance in intensity against the intensity of pixels as measured in a raw input image, as a means of measuring photon capture noise in the noise characterisation of a sensor;
Figure 11 shows an inference device, in this case an NNA of the present disclosure;
Figure 12 shows a computer system in which an inference device and/or a training apparatus is/are implemented;
Figure 13 shows an integrated circuit manufacturing system for generating an integrated circuit embodying an inference device or a training apparatus; and
Figure 14 illustrates a neural network that could be used for a bilateral filter.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Embodiments will now be described by way of example only.

In contrast to the conventional approach of implementing an ISP in dedicated hardware modules that use a streaming (typically linestore-based) architecture comprising a pipeline of well-defined, fixed-function modules, some attempts have been made to train a large, undifferentiated convolutional neural network (CNN) to achieve the same (or similar) output as a handcrafted ISP. Although an undifferentiated CNN can, in principle, model a very wide variety of functions and is thus useful in applications in which we have little prior knowledge of the form the solution ought to take (e.g. image classification), it comes with significant drawbacks including: (i) a lack of modularity, which means that explainability and debuggability are lost; (ii) a large number of parameters (typically of the order of hundreds of thousands to millions) requiring a large quantity of training data and a long training time; (iii) a lack of specialised functions resulting in low computational efficiency (i.e. high bandwidth, a large number of operations, long execution time and high power consumption).

In addition, because undifferentiated CNNs are trained from a general state to a specific ISP state, the functions that are performed by a conventional ISP are not distinct in the CNN implementation and so they are all trained as one. Thus, it is not possible to refine or train a specific function (e.g. demosaicing or denoising or sharpening, etc.) without influencing the other functions. For example, a single loss function may be used to optimise the entire CNN. This means that it is difficult to provide a CNN that can be easily adapted or to improve different functions individually and independently.

While conventional CNNs may be considered "modular" in that operations and neurons are organised into defined units forming layers, these units are generic and dependent for their function on other units. In other words, a layer of a conventional CNN does not have a well-defined function when considered in isolation, but rather can only operate in the context of the rest of the network. When a conventional CNN is trained as a whole to implement an ISP, each unit of the CNN therefore does not represent a distinct functional block (module) of the ISP. For example, it cannot be said that a given unit is "a demosaicer" or "concerned with demosaicing", since this functionality is a holistic property of the network and not a given unit or units within it. ISPs implemented on these CNNs cannot therefore be trained in a modular manner as the architecture of these CNNs requires a holistic training methodology e.g., all aspects of the ISP would have to be trained simultaneously as each unit of a CNN would depend on the function of every other unit in the CNN.

The above approach of training a large undifferentiated CNN does not take advantage of the modular nature of image signal processing or the historical domain understanding that has been gained from handcrafting hardware-implemented ISPs.

WO 2022193514 A1, which is mentioned in the background section above, relates to processor-readable media for training a machine learning-based machine vision system. WO 2022193514 A1 represents the use of a differentiable image signal processor that is trainable using a generative adversarial network. Although the differential image signal processor of WO 2022193514 A1 has some modularity, it would be difficult to implement the modules efficiently on some types of hardware as the modules are not designed with target hardware in mind, or to ensure that the modules are kept functionally distinct e.g. by training individually as opposed to being jointly. Such modules are therefore not optimised for implementation and performing efficient image signal processing on specific target hardware. In addition, the block-wise differentiable ISP of WO 2022193514 A1 includes an enhancement network comprising a convolutional neural network to generate enhanced output images by filtering non-Gaussian noise. This type of enhancement network is undifferentiated and not tailored to perform a specific task; instead, it may perform a variety of functions by learning aspects of denoising, defective pixel correction or robust colour correction for example. This enhancement network of WO 2022193514 A1, which may be connected to the ISP in series with the modules, lacks modularity, which means that the shortcomings discussed above with reference to undifferentiated CNNs also apply to the enhancement network, namely: (i) that explainability and debuggability are lost, (ii) a large number of parameters requiring a large quantity of training data and a long training time, and (iii) a lack of specialised functions resulting in low computational efficiency. In addition, the unpaired approach to training of WO 2022193514 A1 introduces considerable complexity and possible training instability, which in the present disclosure is avoided by the use of a capture model to maintain point-to-point correspondence between the input and reference images during training.

Examples described in detail below provide a solution to the above shortcomings and provide a customisable and adaptable differentiable model ISP implementable on an inference device. The model ISP is modular and can be trained in a less time-consuming manner than tuning a conventional ISP pipeline of hardware modules or one implemented on a large undifferentiated CNN. The model ISP is adaptable in the sense that a module could be removed and replaced with another, without the need to substantially retrain other modules. For example, a sharpening module may be replaced with an alternative sharpening module implementing sharpening in a different way, without requiring substantial retraining of denoiser or demosaicing modules. The inference device may be referred to as a neural network accelerator (NNA) throughout this disclosure by way of example only. Furthermore, in examples described below, the model ISP that is implemented on an NNA is more efficient than implementing a large undifferentiated CNN in terms of the number of calculations performed, the power consumption and the execution time.

In examples described herein, a representation of a model ISP that is formed of distinct modules, each module being configured to implement a functional block of an ISP pipeline that performs a predetermined task of the ISP pipeline, for example, denoising (the denoising module). The task of each module is distinct from the tasks of other modules in the model ISP. Each module may comprise a series of layers or steps that may be performed to execute that task, but these steps are confined to the module in question and do not affect the other modules. In other words, in the model ISP there is a module to task relationship, which is on a one-to-one basis. Therefore, each module of the model ISP will correspond to a specific single task performed by the ISP pipeline. This modularity and relationship between modules and tasks of an ISP pipeline as in the present disclosure allows for improved trainability as each specific module of the model ISP and thus each task can be trained independently, as will be described later on. It also improves explainability and debuggability, and allows any modifications to be limited to the module corresponding to a given task.

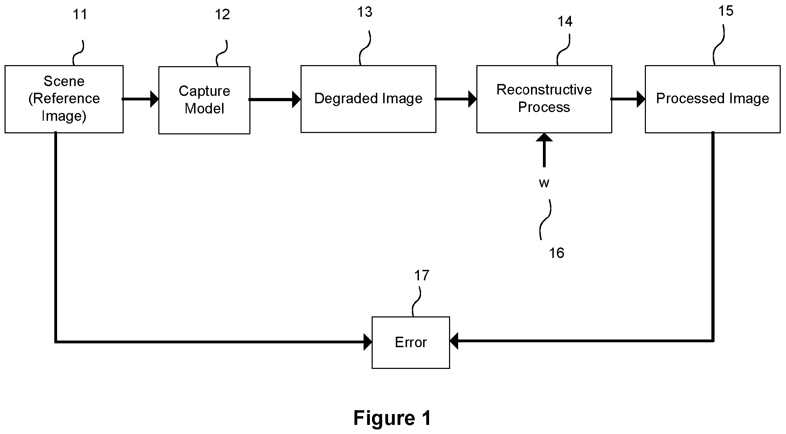

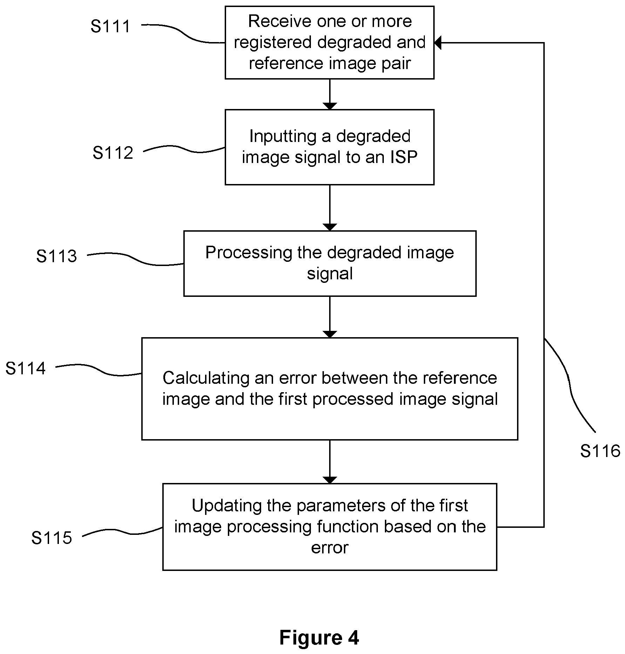

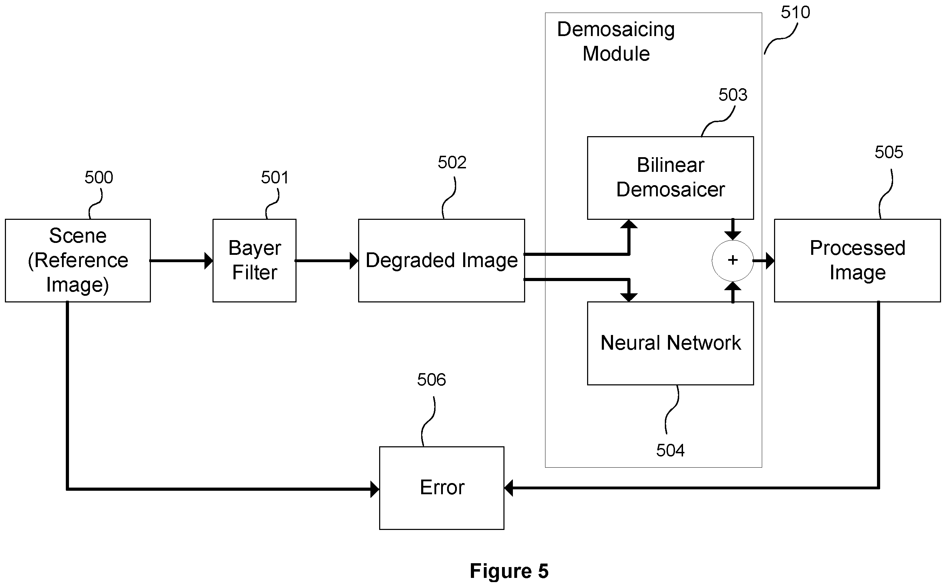

Figure 1 depicts an overview of a general training set-up that applies both to training individual modules and to fine-tuning the model ISP as a whole (once each module thereof has been trained independently) while figures 5, 6 and 7 demonstrate training of single modules. In figure 1 the reconstructive process may be performed by a model ISP represented as a neural network in a deep learning framework (for example software such as TensorFlow or PyTorch that may be used for defining and training neural networks). Such a reconstructive process depicted in figure 1 may be executed, for example, on a CPU or GPU for the purpose of training the reconstructive process. The image capture model may be modular and designed and configured (e.g. using measured characteristics of a physical image capture apparatus) to simulate a physical image capture apparatus (e.g. a camera). The reconstructive process is intended to minimise an error 17, which may be calculated between a reference image 11 and an image 15 output from the model ISP, as will be described in more detail below. Minimisation of this error is achieved when the processed image 15 matches the reference image 11 as closely as possible, i.e. degradation introduced by the capture model 12 is as nearly as possible inverted by the reconstructive process 14. Such an approach may be referred to as an "autoencoder approach", by analogy to autoencoder architectures known in the deep learning art. Figure 1 demonstrates how an image capture model and reconstruction process combine in producing a processed image from a reference image, which may be an image of a scene, for training purposes. An RGB (reference) image 11 may be passed through a capture model 12. A capture model 12 may be comprised of a number of components, for example there may be a part of the capture model 12 that imitates/models/simulates a lens. In other words, a portion of the model may imitate the effect a part of the image capture process, such as a specified lens, would have on the reference image and apply such an effect, usually a degradation, to the reference image as it passes through that part of the model. The capture model may comprise one or more different configurable components, which may be thought of as modules, each of which may represent an effect that may be applied by a real-world camera when capturing an image. By configuring these components, the capture model can be adapted to specific camera properties and thus model any desired camera/device capable of capturing an image. As such, the reference image 11 is processed by the image capture model 12 to generate a corrupted/degraded version (the raw input image for the reconstructive process 14) of the input, where information has been lost (or, equivalently, artefacts introduced) due to the simulated capture process. Such degradation will be an accumulation of the modular degradations (artefacts) introduced by the capture model 12. This is the same (or similar) degradation that would occur when a physical camera captures an image due to effects such as lens blurring etc. A reconstructive process 14 may process the corrupted/degraded image 13 produced by the capture model 12 to generate an output 15 the same size and shape as the reference image, with the same number of channels (three in the case of an RGB image). Generally, the reconstructive process will mirror the capture model and attempt to invert the degradations/artefacts introduced by each module of the capture model 12. Since this reconstruction (inversion) problem is ill-posed (there are many possible reference images 11 that could result in the same degraded image 13), it may be solved as an approximate best fit to given data, hence the use of the numerical optimisation (i.e. training) method described in relation to figure 4 below. Other known image sizes and numbers/types of channels may be used instead of RGB, which is used here by way of example. The ISP may take as further inputs parameters 16 that may be trained as part of the process shown in figure 1. Such a reconstruction process (in this case the use of the model ISP to invert the degradations of an image capture process) may be viewed in terms of reducing or minimising an error (which may be thought of as a "reconstruction error") between the reconstruction of a captured degraded image and an ideal reference image, or more intuitively as correcting an aspect of an image signal that has been corrupted by a capture process. An image signal may be considered to be raw sensor data, or raw sensor data that has been modified. The image signal represents an image and may include information such as pixel values. Reduction of reconstruction error is hereinafter also referred to as "restoration", "reconstruction", "refinement" or "correction".

After the reconstructive process 14 (model ISP) has been trained to the desired level (i.e. to minimise the error between the reference image (scene) 11 and the processed image 15), it may be put to use. The reconstructive process 14 (model ISP) may be put to use by deploying it onto an inference device such as an NNA. An inference device may be optimised for efficient execution of a predetermined set of operations, and may not provide support for backpropagation or training (that is, the inference and training devices may be different). The inference device may be used to apply the reconstructive process to degraded images, produced by an image capture apparatus (e.g. a camera) that the capture model 12 was designed to simulate. In this way the deployed reconstructive process can (at least partially) invert degradations introduced into newly captured images by the image capture apparatus.

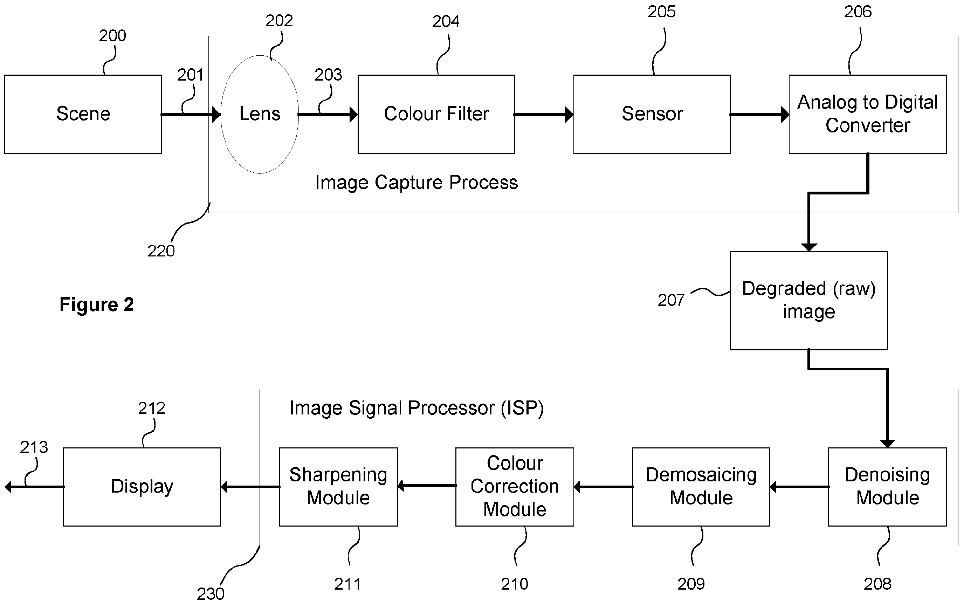

Reference is now made to figure 2, which illustrates an overview of an example image capture process and an example reconstructive process in the form of an ISP pipeline, in other words the implementation of a reconstructive process (i.e. in use, after the training depicted in Figure 1). An example of this is the implementation of a differentiable model ISP on an inference device (NNA). In such a case the differentiable model ISP may be first converted into a command stream that can then be executed on the inference device (NNA), which configures the inference device to function as an ISP. The neural network accelerator (NNA), which then functions as an ISP is used to invert at least a portion of an image capture process 220 performed by a camera by processing a degraded (or "raw") image 207 to improve the image quality, resulting in, for example, an output image 213 that would be perceived to be of a high quality, e.g., to a human viewer. The image capture process 220 that the NNA is configured to invert will correspond to an image capture model (block 12 from figure 1) that was used to train the reconstructive process 14 (differentiable model ISP) and therefore image capture model 12 simulates the image capture process 220 of a real camera or other image capture apparatus. In some cases, the inference device (NNA) may be configured to implement a command stream representing a differentiable model of an image signal processor as a combination of operations from a set of elementary neural network operations which are available on the inference device. It should be noted that the command stream itself is not differentiable and once the differentiable model ISP is converted to a command stream, the differentiable property of the model ISP is lost. The inference device is thus configured to implement a model ISP to reconstruct an image that has been 'corrupted' during the image capture process 220. An overview of the implemented reconstructive process 230 can be seen in figure 2, which corresponds to the reconstructive process 14 of figure 1, and may include one or more modules of a model ISP, where each module of the model ISP may have been trained separately from the other modules as described herein.

Figure 2 shows an example image capture process and an example image signal processing pipeline (reconstructive process) used to correct the captured image for display. Generally, the image capture process results in a corrupted version of an image. The corrupted/degraded image may contain for example noise, incorrect colours, and missing samples (due to the use of a colour filter array). As can be seen in figure 2, when a scene 200 is captured by an image capturing device, such as a camera, the light (image) 201 typically passes through a lens 202 of the image capturing device, which will cause some distortion to the image. This distortion may be in the form of a blur and/or other distortion(s) and is a form of corruption of the image captured. The characteristic forms of degradation (such as blurring) caused may be termed "artefacts". The distorted image 203 may then pass through one or more colour filters 204 or colour filter arrays, for example a Bayer filter. Further information relating to the distorted image is therefore lost, for example a Bayer filter will remove information relating to two of R (red), G (green) or B (blue) colour data for each pixel. The remaining information may then be detected using a sensor 205 and may be passed to an analogue to digital converter 206 as part of the image capture process. This creates a digital representation of the scene that has been captured. This digital representation may form the base raw image data (degraded image) 207 in which each pixel contains only partial information regarding the scene that was captured. This raw image data may be thought of as an image of a scene that has been degraded (corrupted) during the image capture process.

As can be further seen in figure 2, in order to restore the degraded raw image 207 to an image that can be displayed to the user, the image may undergo image signal processing (e.g., a reconstructive process). This image signal processing may be performed by an ISP pipeline, each module of which may perform a function that corrects an aspect of the degradation of the image caused by the image capture process. An example of this may be that the image signal processing pipeline may include a sharpening module that is intended to reverse the blurring effect caused by the lens in the image capture process. The image signal processing pipeline shown in figure 2 includes a denoising module 208, a demosaicing module 209, a colour correction module 210 and a sharpening module 211. Each of these modules of the image signal processing pipeline shown in the example of figure 2, are shown for explanatory purposes only as once the image signal processing pipeline is deployed on the inference device, the modules cease to be distinct from one another, however the overall functionality of the trained modular model ISP is contained within the command stream that represents the image signal processing pipeline (as explained in more detail below). Each of the blocks of the image signal processor of figure 2 therefore represent separate tasks of the pipeline and can be considered distinct functional blocks performed by the pipeline prior to them being converted to a command stream for implementation. In other words, the blocks 208, 209, 210 and 211 of the image signal processor of figure 2 represent modules of the differentiable model ISP, for explanatory purposes only, such that the connection between the differentiable model ISP and the implemented ISP can be understood. This image signal processing pipeline may be implemented on an NNA using a model image signal processing pipeline with modules which correspond to modules of the desired image signal processing pipeline. The image signal processor, an example of which is shown as blocks 208, 209, 210 and 211 of figure 2, may be modelled as a model ISP for training purposes (e.g., as the reconstructive process 14 shown in Figure 1), prior to implementation.

Once the raw image has been processed by the ISP pipeline, the image may then be displayed 212 to the user by outputting light 213 that represents the light 201 from the originally captured scene 200 via a monitor or similar display means 212. Arrow 213 represents the light from the display means.

The image capture process 220 may be simulated using a mathematical capture model 12, as previously introduced with reference to figure 1. This makes it possible to have pixel perfect registration between the reference and corrupted images, which is vital for training, and avoids the need to use complex unpaired training methods such as General Adversarial Networks (GANs). This pixel perfect registration would otherwise be very difficult to achieve, e.g. with a physical camera and reference chart. A further reason for simulating the image capture process is that it is then possible to selectively enable and disable parts of the capture model 12, which allows modularity to be preserved when training the ISP. Again, this is very difficult to achieve with a physical capture process as, for example, any image captured must be captured using a lens and sensor, and thus the parts of the capture process pertaining to these cannot be removed. Simulating an image capture process 220 also allows for the possibility of creating new data without the need to perform new captures and further provides the ability to use "ideal" scenes for training, i.e., pixel-perfect test patterns not possible when physical captures are used. In other words, each aspect of the image capture process 220 may be mathematically modelled and combined into a model 12 of an image capture pipeline as is known in the art making it possible to achieve the above effects. An example of this is that the manner in which the light travels through a lens may be described mathematically and implemented for example in software, such that when an image is input to the mathematical model, the effect of the blurring that the lens would apply to the image also occurs when the image is processed by the model.

The capture model 12 may be furnished with parameters that govern its behaviour, for example a Gaussian blur for modelling a lens may be parameterised by its variance, and the capture noise of the sensor may be represented using a parameterised random distribution. The structure of the capture model 12 may thus be largely the same for a diverse range of distinct cameras, as it provides a framework into which the measured characteristics of a given camera may be input to configure its behaviour to correspond closely to the capture process 220 of that camera. The parameters/characteristics of the physical camera may be measured under controlled conditions in a process which may be referred to as "characterisation". Such controlled conditions may include the use of an imaging lab with controlled lighting, exposure, gain, test charts, etc. The experimental setup may differ depending on which parameters are desired to be measured. This process typically requires manual operation and has a time scale of a few days, but it should be noted that it only has to be performed once for a new sensor and/or lens. This characterisation of the properties of the camera may then be used to set the capture model 12 in order for the model to imitate the desired camera. Some examples of parameters of the capture model 12 are the noise strength, the amount and type of lens blur, the colour space conversion required, etc. The capture model 12 described herein is designed in a modular manner, in a similar way to the model ISP (reconstructive process) 14 as seen in figure 1. This makes it possible to bypass/selectively disable portions of the capture model 12 and model ISP 14 for training purposes, so that individual modules of the model ISP 14 can be trained in isolation from other modules of the model ISP.

In some examples, parameters of the capture model 12 may be manually changed from the measured values from the physical camera in order to achieve a certain aesthetic effect. For example, the strength of the lens blur may be artificially increased ("over-blurring") in order to achieve stronger sharpening in the ISP, which when applied to an image captured with the physical camera results in an artificially sharper image.

The reconstructive process (model ISP) of figure 1 may be represented using one or more modules. Although figure 2 demonstrates the implementation of an ISP 230, to invert the capture process 220, the ISP 230 is shown as having modules in order to better explain the function of the implemented ISP in relation to the model ISP (reconstructive process) 14 of figure 1. The model ISP (reconstructive process) 14 of figure 1 may include the same modules as shown in the ISP of figure 2. The modules of the model ISP are differentiable to allow for training. This differentiability is lost when the trained model ISP is implemented as a command stream on an inference device as shown in figure 2. The four example modules correspond to various degradations that are introduced to the image during the capture process 220. Each module of the model ISP 14 represents a specific task performed by the ISP pipeline and may correspond to one element of the corruption introduced during a capture process 220/capture model 12 as described above.

A task can be considered to be a functional block of the ISP pipeline. Each of the functional blocks of an ISP pipeline may be performed by a separate module of the model ISP 14 that is then implemented as a command stream on an inference device. Each of the modules of the model ISP 14 may only implement one functional block (task) of the ISP pipeline, thus allowing each module to be independently customised and trained to achieve the desired functional block operation. The series of modules of the model ISP 14 will process the image input in a sequential manner, each reconstructing one aspect of the input image by performing e.g., denoising, sharpening, demosaicing, etc. In other words, a functional block of the ISP pipeline may be embodied by a module: for example, there may be a denoising functional block that is achieved by the processing applied by a denoising module 208. The capture process includes a lens 202 that introduces blurring to the image, and the ISP pipeline includes a sharpening module 211 that will invert the blur introduced during the capture process. Each module of an ISP may be represented by multiple layers or operations of a model ISP. Furthermore, when the model ISP is implemented on an inference device (through conversion to a command stream that is executed), each of the layers or operations of the model ISP may map to one, part of, or multiple hardware modules on the NNA, described later. Most commonly, the order in which the image processing modules are applied is approximately the reverse of the order of the corresponding physical capture processes that degraded the image 201.

In figure 2 the model ISP pipeline when implemented after training would include the functions that relate to a denoising module 208, demosaicing module 209, colour correction module 210 and sharpening module 211. The training of some of these modules is described below with reference to figures 5, 6 and 7. The raw image data that is output from the image capture process may be processed by each of these modules sequentially until each module has acted on the raw image data/image signal.

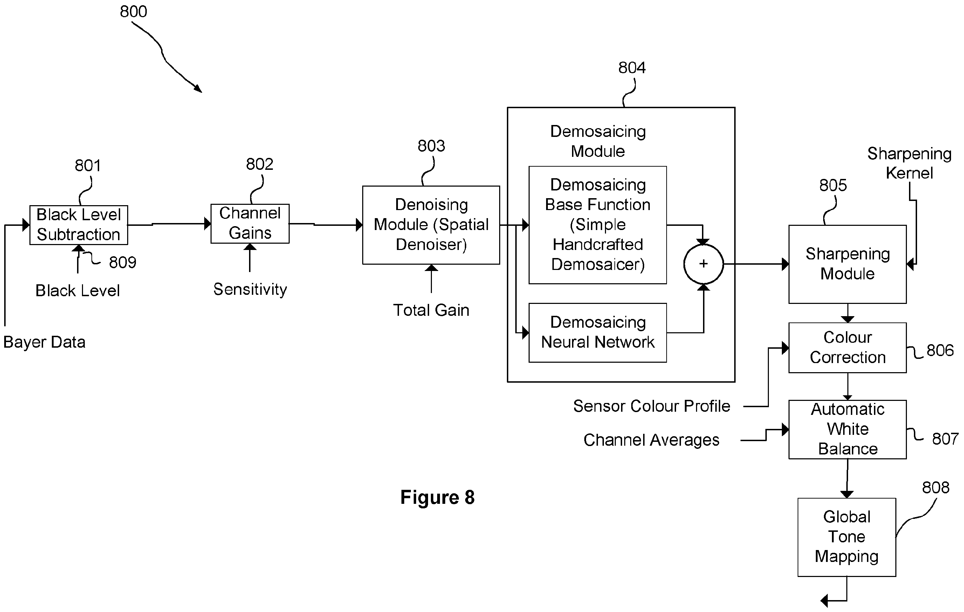

The model ISP 14 described above may comprise at least two modules, e.g., two or more of the aforementioned modules. Each of the above modules is functionally distinct from the others and thus can be trained and/or used independently to process an image/image signal. The modules of the model ISP may be arranged in a pipeline as shown in figures 2 and 8. Although modularity and differentiability are important during training, they are unimportant at deployment and as such, the deployed model ISP may not preserve modularity or differentiability. However, the behaviour of the model ISP in processing an input image is retained.. As such, the image initially input to the inference device is refined by the inference device according to the behaviour of the model ISP comprising the at least two modules, before being output. In the context of this disclosure "refined" may mean processed by one or more modules or an inference device, each module (or the inference device) performing a functional block of the ISP pipeline in order to produce an image of improved quality in one regard, for example, in the case of the model ISP the denoising module will process the image to reduce the noise in the image. "In one regard" should be understood to mean the way in which the module (functional block) that performs a single task is intended to process the image (as distinct from the ways in which other modules of the ISP may process the image). The modules and the model ISP as a whole when implemented on an NNA after being trained should have the desired function of inverting the capture process of a given physical camera.

Once the capture model 12 has been created it may be used to train the model ISP 14 pipeline to function to invert the degraded images 13 produced by the capture model 12 and thus, when implemented, invert the capture process 220 of a physical camera. This is because the capture model 12 will, if correctly formed, imitate the capture process 220 of the physical camera providing the same degradation to reference images 11 as the physical camera would to captured images 200. It is this degradation that an NNA functioning as a model ISP is intended to reduce/invert in order to produce a processed image that is a true representation of the original scene 200, when applied to the output of a given camera.

The differentiable model ISP is trained using the process described below to produce processed images that correct the degraded images that may be produced by the capture model.

As an example in which a model ISP is produced for configuring an inference device to function as an ISP, a capture model is first produced that is a general model with parameters that allow the model to represent a specific camera having properties of the camera built in. Once this capture model has been produced, it may be used to produce degraded images 13. This may be done by degrading a reference image 11. The reconstructive process 14 (representing the model ISP) will then receive the images/image signals degraded by the capture model and perform the function of the ISP, attempting to invert the degradation caused by the capture model in the image. As will be understood the degradation applied to the reference image 11 in order to produce the degraded image 13 is related to the function (first/second image processing function) performed by the module or modules of the differentiable model ISP to be trained as part of the reconstructive process 14. This allows the reference image 11 to be compared to the image that is output when the degraded image 13 is processed by the module or modules that are being trained. An example of this is that if the denoising module 208 is to be trained, the reference image 11 will be degraded to introduce a known amount of noise to the reference image 11 to produce the degraded image 13. The degraded image 13 containing the introduced noise degradation can then be used to train the denoising module 208 which will be configured to invert the degradation and return the degraded image 13 as closely as possible to the reference image 11. The model ISP is trained (by adapting the parameters 16 of the reconstructive process 14) so that processed images 15 are as close as possible to the reference image. When the model ISP has been trained it can be converted to a command stream to be implemented on an inference device, such as an NNA. This inference device can then be used to process a degraded image 207 received from an image capture process 220 in order to determine an image.

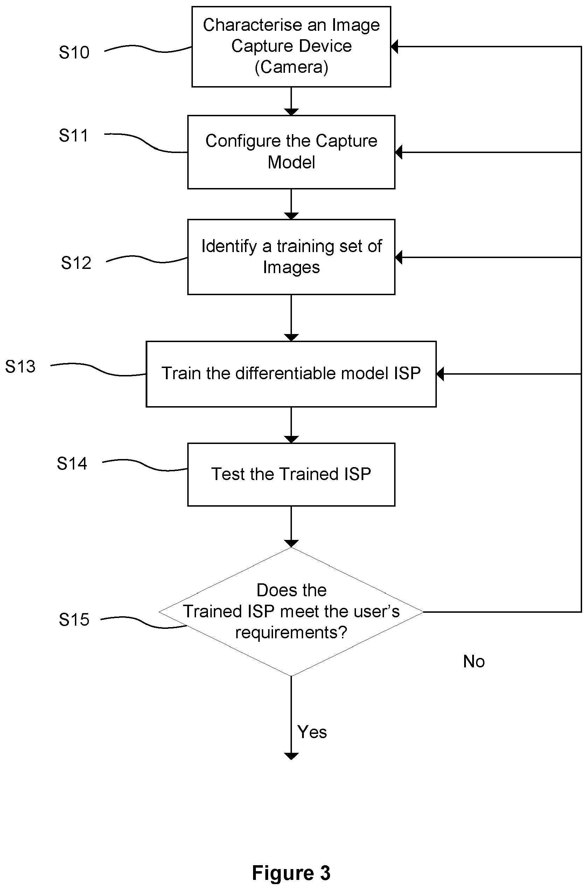

A high-level procedure for training a differentiable model ISP to correct for the characteristics of a particular capture model (simulating an image capture apparatus) is now described in relation to figure 3. The first step S10 of the general training process is to characterise an image capture apparatus (camera) whose captured images the user wishes to correct/enhance with the eventual trained ISP that is implemented as a command stream on an inference device. Characterisation of a camera is described in greater detail later in this disclosure, however, in general the characterisation of a camera may include characterising each of the aspects of the camera, for example the lens, sensor that detects the light etc. Such characterisation involves defining the properties of the camera in question.

Once the camera has been characterised and its properties are known, the user then configures a capture model to mimic those properties and thus simulate the camera mathematically. In this step S11, each aspect of the camera is modelled as a portion of the capture model. For example, the lens is mathematically modelled and imitated by a portion of the capture model such that when an image that is processed by that portion of the capture model, it is degraded in the same way that it would be if it had been viewed through a lens, e.g., the artefacts found in the image will be the same. This is true for each part of the camera such that once the capture model is configured in step S11 it represents a model of the camera that was characterised and would then process an image in the same way as the camera would in a controlled manner. Optionally, the capture model may be configured (in part) based on the requirements of the end-user of the ISP. In other words, the capture model may be configured to further adapt the input images to suit the needs of the user, for example to perform a greater degree of blurring than would be ordinarily performed by a camera.

After the capture model has been produced in step S11 it may be used to degrade reference images to produce reference image and degraded image pairs that can be used to train the differentiable model ISP prior to implementation on an inference device. Prior to the training of each module of the differentiable model ISP a set of training images is obtained that can be used to iterate through the model ISP in order to refine it. As such, step S12 may be performed in which a training set or multiple training sets of images may be identified for the training of each module. These training images may for example be artificial test images, natural photographs or a mixture of the two. The skilled person will appreciate that any appropriate image can be used in this step. These images may be considered reference images and may already have corresponding pixel-perfect registration degraded images that correspond to them on a pixel-to-pixel basis. However, where such pairs with perfect correlation do not exist, the reference images will be input into the capture model to identify a training set of images formed of the input reference image and a paired degraded image that has been processed by the capture model and thus has the appropriate artefacts introduced, for example in relation to the training of the sharpening module the artefact introduced by the capture model processing may be a blurring effect.

Once the training set or sets of images have been identified they may be used to train the differentiable model image signal processor in step S13 as is described below in detail in relation to figure 4. As will be described the differentiable model ISP is trained on a module-by-module basis to begin with and only once this has been completed is the model fine-tuned as a whole.

After the differentiable model ISP has been trained in step S13 using the identified training images, it may be implemented to process images from a physical camera, as in step S14. In such a case, the differentiable model ISP may be converted to a command stream which will then be implemented on an inference, or other suitable, device such as a neural network accelerator, or alternatively may be run on the same device used for training for testing purposes. When implemented on an inference device the command stream will cause the inference device to reproduce the function of an ISP having the trained properties and thus, in the case of this disclosure, inverting the capture process of a physical camera. The results from processing test images may be compared to the reference images to test whether the inference device functioning as an ISP meets the requirements of the user. The user may then determine S15 whether the trained ISP implemented on the inference device performs the correct image processing (inversion of the capture process of the camera) or whether further training is required. Once such an evaluation by the user S15 has been made, the user may return to any one of steps S10 to S13 to correct the deficiencies if required in order to produce a more accurate recreation of the capture image or to customise the processing performed by the implemented ISP, for example by retraining a given module and/or altering the mathematical function defining it, or choosing a different set of training images. This process continues until the functioning of the trained ISP meets the requirements of the user, at which point a command stream is prepared for configuring the inference device to reproduce the functionality of an ISP, shown by the "Yes" arrow in figure 3.

In some cases, steps S10 to S12 may be bypassed or omitted from the process where a suitable set of registered ground truth (reference images) and degraded images is available by other means, e.g., by controlled physical capture in lab conditions. However, it is expected that the approach using the capture model is overall much more efficient from the point of view of the engineer. The skilled person would therefore understand that steps S10 to S12 of this process are optional if reference and degraded image pairs are available. In this context, "registered" means that there is a direct spatial correspondence between two images (e.g. between a ground truth and a degraded image pair).

The training method and training apparatus for training a differentiable model of an image signal processor will now be described in relation to figure 4. The model ISP may comprise at least two differentiable modules. The training method will be described first, followed by a description of the training apparatus that may implement the method.

The training method may be used for training a differentiable model of an ISP that may comprise at least two modules. As described above, each of these modules performs a function that is independent of the other modules. Furthermore, each of the modules is separate (i.e. distinct) from the other modules that form part of the model ISP. Each of the modules of the model ISP are configured to perform a respective single image processing function of an image signal processing pipeline, for example, the demosaicing module only performs a demosaicing function and does not perform a sharpening function. The method of training comprises receiving a reference image and may include processing it using a capture model with known properties, to produce a degraded image that has a pixel-perfect registration with the reference image. In other words, the pixels of the reference image can be compared to those of the degraded image which correspond on a 1 to 1 basis. For example, the capture process/model will have known properties, such as those related to a specific image capture device that the capture model is imitating, and thus the degradation that is applied to the reference image will be known. As previously noted, registered image pairs obtained by other means, or precomputed in an offline fashion using a capture model, may instead be used. For example, in some cases one or more pairs of (registered) reference images and degraded images received may have been captured using a controlled, physical capture apparatus to correspond to each other on a 1 to 1 basis prior to be being received. Alternatively, as discussed above, the method may include a step of degrading a received reference image to produce a degraded image that corresponds to the reference image.

In some examples, the training of the modules may be batched, i.e. multiple image pairs (reference and degraded) input to or output from differentiable model ISP may be processed simultaneously and gradients may be accumulated before updating the parameters of each module. In this way groups (batches) comprised of pairs of images may be used in the training method for the one or more modules in order to simultaneously consider the gradients resulting from each image pair and increase the speed, convergence, and accuracy of the training process.

Training of the modules of the model ISP takes place on a module-by-module basis. As such, while each module is being trained, the modules that are not being trained are fixed, e.g., the parameters that form the functions of the other modules are fixed and unchanged. This allows only the parameters of the module that is being trained to be updated without affecting the behaviour of the modules that are not being trained. This ensures the preservation of the independence of modules, by removing the possibility that each module (e.g., the demosaicer) attempts to correct for errors introduced by an unrelated part of the capture process (e.g., lens blur, which might be intended to be addressed by a different module for example a sharpening module). This ability to preserve modularity during training is an important advantage of using a configurable capture model.

The training method may differ between modules and may proceed as follows, described in relation to figures 1 and 4. A specific example of the application of the training method for single modules is described later in in this disclosure in relation to figures 5, 6 and 7 showing the training of a demosaicing, denoising and sharpening modules.

The training method for training a model ISP that may be implemented on an inference device, such as an NNA, according to this disclosure, is as follows. The model ISP, that is implementable on the inference device, may comprise at least two modules, where each of the modules is configured to perform a respective single image signal processing function. The method for training the model ISP may comprise receiving one or more registered degraded image and reference image 11 pairs. In some cases the reference images 11 may be data, possibly in the form of either an image or image signal, that are input to the capture model 12 in order for the capture model 12 to degrade the reference images 11 in the same way as the hardware (image capture apparatus) that the capture model is imitating would. Such hardware may be a specific camera having image capture properties that the capture model then imitates.

Preferably, a capture model 12 may be used to degrade the reference image 11 to form a degraded image 13 that can be used to train the model ISP (step S13 of figure 3 or step 112 of figure 4). However, degraded image and reference image pairs may be used that do not include images degraded by a capture process but are instead derived from controlled captures using a physical camera. In the case in which the reference images are degraded by processing with a capture model, at each stage of the process, corruptions may be introduced to the image. This leads to the production of an image 13 that is degraded compared to the reference image 11. The image is degraded by a known amount as the sensor that captures the image will have been characterised, and thus the properties will be known. As discussed above, images with a known degradation may be used so long as they have a corresponding reference image and represent a degradation of the reference image 11.

A first module of the reconstructive process (model ISP) 14, that performs a first image signal processing function is then trained (i.e., optimised with respect to an error 17) using an iterative numerical method. When training the first module, no other modules that are part of the model ISP 14 are trained, e.g., as discussed above the parameters (that may comprise weights) of these modules that are not being trained remain fixed, unchanged, or are removed/bypassed. In this way only the first module is trained in the following steps. During the training of the first module an image signal of the degraded image 13 will be processed by only the desired module to be trained in the model ISP pipeline 14 and only the parameters of the first module will be adapted based on the outcome.

The training of the first module includes a step (step S112) of inputting to the model ISP a degraded image signal (or a batch of degraded image signals) 13. The degraded image signal is an image signal that represents a known degradation of the reference image signal by the capture model 12 shown in figure 1. Alternatively, reference images 11 and degraded images 13 may be used in place of the respective image signals. For example, in the case of training the denoising module, the degradation applied to the reference image signal is applying noise 201, to an image to degrade it. The characteristics of the noise that is applied to the reference image is controlled and known to the user.

Once the degraded image signal 13 has been input to the model ISP 14, the degraded image signal 13 is processed (e.g., "corrected") in a step S113 using the model ISP pipeline in order to produce a first processed image 15. The model ISP processes the degraded image signal in step S113 using the model ISP pipeline. In other words, passing the degraded image signal 13 through each of the active modules of the model ISP in succession in order to refine the properties of the image. Here the active module is the module that is being trained, while the inactive modules are the modules that have been removed or that are bypassed and thus may be considered absent from the processing pipeline of the model ISP.

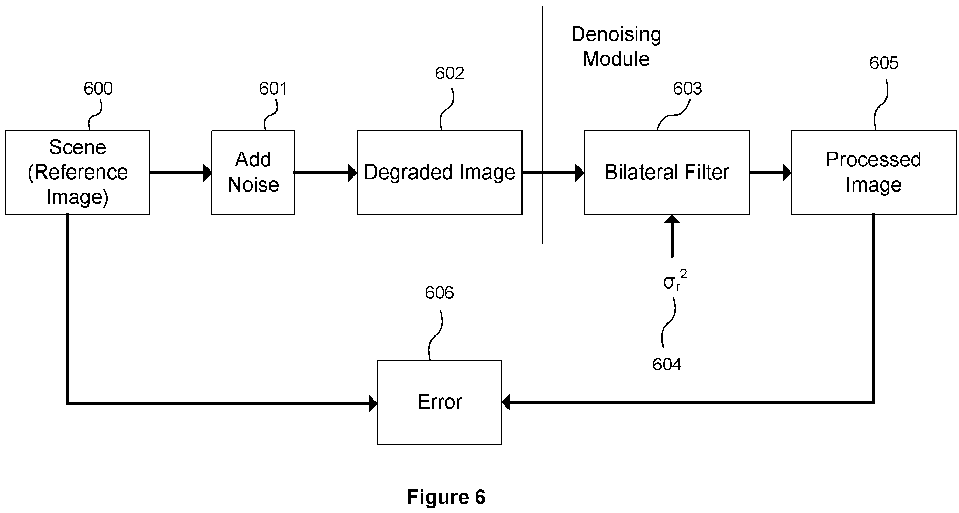

Taking the denoising module as an example, the degraded image will be processed by the model ISP pipeline that includes a denoising module that may implement a bilateral filter 603 (see figure 6) for performing bilateral filtering as a first image signal processing function. The bilateral filter 603 may include a variance parameter that governs the selectivity of the filter, and this may be trained during the training method. The denoising module of this example will output a first processed image 605 but, in other examples it may instead output a first processed image signal representing the first processed image 605. The first processed image 605, 15 is an image that is partially corrected back towards the reference image 11 using the modules of the model ISP 14. In particular, in reference to the training of the denoising module, the first processed image 605 will be an image in which the noise of the degraded image 602 has been at least partially reduced by the denoising module.

The first processed image 15 is then compared to the reference image 11 in order to calculate an error 17 (in step S114) between the two. Reducing this error 17 corresponds to "correcting" or improving reconstruction quality of the image, or equivalently inverting the capture process. The error 17 between the first processed image 15 and the reference image may be calculated in any suitable way. Minimising the error corresponds to providing the best correction possible by updating the parameters and/or weights of the functions that make up each module of the model ISP. The aim of the training is to reduce the error between the first processed image and the reference image (i.e. the difference between the processed image and the reference image will be small). This is achieved by minimisation of the error which may be as follows.

$$w^* = \operatorname*{argmin}_{w} \left( \sum_{x \in X} \| g\left( f(x), w \right) - x \| \right)$$

Where $w^*$ is the ideal parameters of a module/the model ISP, $x$ is a particular image, X is the training set of images, $f$ is the capture model and $g$ is the parameterised ISP (with parameters (including weights $w$)). Training the model ISP to invert the degraded images from the capture mode is undertaken in the same way as solving the above general optimisation problem, by choosing optimal parameters $w^*$. The term inside the argmin is an example of an error between a reference image and a refined output image that should be minimised. This minimisation corresponds to training the module parameters of the model ISP.

Once the error 17 between the first processed image 15 and the reference image 11 has been calculated, the parameters of the first image processing module that is being trained are updated based on this calculated error 17 in step S115. Such updating may involve updating, in other words changing, the parameters of the function performed by the module. Only the module being trained may be updated in this step S115. This may be done by a numerical optimisation algorithm such as gradient descent by backpropagation of errors. Gradient descent is a class of numerical optimisation algorithms that include stochastic gradient descent and Adam optimisers. The gradients themselves may be conventionally computed by backpropagation. In other words, gradient descent is built upon backpropagation. Where a gradient is to be calculated using backpropagation of errors for the purpose of training, it is important that the modules in the ISP pipeline should be differentiable. Tools for defining differentiable computational graphs, and performing backpropagation and gradient descent-based optimisation, are commonly available in deep learning frameworks such as TensorFlow and PyTorch and may therefore be used for the training of such an ISP according to the methods described in this disclosure.

In the example of a denoising module which includes a spatial denoiser that implements a bilateral filter 603 with a parameter of (range) variance (see figure 6) as the base image processing function 603, for a standard optimisation algorithm (using gradient descent with backpropagation) to be effective in training using the above method, the algorithm of the bilateral filter must be differentiable. In other words, it must be possible to backpropagate the (derivative with respect to the) error through to the parameter being trained so that it can be updated. In the case of the denoising module including a spatial denoiser as shown in figure 6, the trainable parameter determines the strength of the filter. Too strong or too weak a filter will cause an undesirable error on the output. It is therefore advantageous to minimise the output error by choosing an optimal denoiser strength that balances preservation of features (e.g., detail and edges) while removing as much noise as possible.

Since the above training is an iterative process, once the first image processing function of the module being trained has been updated, the iterative steps are repeated, indicated by the arrow S116 of figure 4. In other words, the same or different degraded image(s) is/are input to the model ISP and again corrected using the model ISP. However, in this subsequent iteration, the module that is being trained processes the image according to the updated parameters of the base image processing function, producing a further processed image that is corrected by a different amount from the first processed image. This may be an improved correction that brings the properties of the further processed image closer to those of the reference image. The further processed image is then compared to the reference image, in the same manner as discussed above, and a new error is calculated based on this comparison. This error is then used to again update the parameters of the base image processing function of the module that is being trained and again the iterative process may be repeated until a termination condition has been met (for example, training has proceeded for a desired number of iterations, or an error has been brought within tolerable bounds). In some cases, it may be desirable to update some parameters of the module and not others, for example the parameters relating to the base image processing function or those related to the refinement processing function (as described below), or alternatively, a portion of the parameters of the first processing function and/or the refinement processing function.

The training method may further include that the iterative process stops when the error 17 between the processed image 15 (first or subsequent) and the reference image 11 is less than a threshold. This threshold may be set by the user or automatically calculated as a percentage of the property that is being trained. For example, taking the case of the denoising module, the threshold may be that the error 17 between the processed image 15 and the reference image 11 is within a certain predefined tolerance. In some cases, the error used for determining when to stop training may differ from the error used for optimisation. This for example may be done where the measure of error 17 used to judge image quality is not differentiable, and we instead optimise by means of a differentiable function.

Alternatively, instead of stopping the iterative process when a threshold is met, the iterative process may stop after a set number of epochs, or a set length of time has passed. In other words, there may be a finite number of iterations set and once these have been performed the iterative process will cease. This allows, in some cases, for a training schedule to be set where each module of the model ISP is iteratively trained for a set number of iterations/epochs/time period before moving to the next module.

In some cases, the first module, e.g., the module being trained, may comprise a base image processing function as mentioned above, that performs the task to be performed by the module. In some cases, there may be provided base logic configured to receive an input image signal and to process the received input image signal by performing a base image processing function that represents a task of the functional block of the pipeline implemented by the module. The module may further be comprised of a refinement function in the form of a small neural network. In this configuration, the base image processing function may also be comprised of the base image processing function and the refinement function performed by the neural network. When the base image processing function is updated in the final step of the iterative process discussed above, the parameters 16 of both the base image processing function and those of the refinement function are updated simultaneously. In this way, when a module includes a refinement function as a neural network, the neural network within the module may be trained and refined as part of the iterative process. The same is true of the base image processing function that is performed by the module. However, this may not be the case and instead of simultaneously updating the parameters of both functions, only the parameters of one of either the base processing function or the refinement function may be updated. Alternatively, only a portion of one or both of the functions may be updated based on the refinement (adaption) that is required.

In some cases, there may be provided a refinement function configured to receive the input image signal and to process the received input image signal in parallel to the processing of the received input image signal by the base logic. There may also be provided combining logic configured to combine the processed image signal from the base logic and the processed image signal from the refinement function to determine an output image signal to be outputted from the differentiable module. In other words, each module may be thought of in some examples as a differentiable module of a differentiable model of an image signal processor, the image signal processor comprising a pipeline of functional blocks, wherein the differentiable module is configured to implement a single functional block of the pipeline, the differentiable module comprising the base logic, refinement function and combining logic discussed above. The refinement function may be configured to process the input image signal in a manner such that the combining logic corrects an error remaining in the processed image signal from after the base logic has processed the received input image signal.

In updating the parameters of the base image processing function and/or refinement function, said parameters may be updated based on at least one first pre-set learning rate. The learning rate may be a scale factor by which to multiply the gradient of the error with respect to the parameters before incrementing each of the parameters. The learning rate is a hyper-parameter which is set empirically by the user. Typically the first pre-set learning rate may be set at a positive value significantly smaller than 1 (typically in the range $10^{-3}$ to $10^{-6}$). More generally, depending on the choice of optimisation algorithm, the first pre-set learning rate may be as high as $10^{-1}$ or as low as $10^{-9}$, in other words, in the range $10^{-1}$ to $10^{-9}$. Such a value is chosen so that, when multiplied by the gradient of the error with respect to a given parameter, it results in a small adjustment to the value of that parameter. Too large or small a learning rate will typically prevent convergence in reasonable time. In this way small adjustments can be made to the parameters in each iteration. It should be understood that the learning rate may be different for each module and/or parts of that module. For example, the denoising module may have a different learning rate than that of the demosaicing module. In addition, the refinement function within a module may have a different learning rate from the base image processing function. The relevant learning rate may be applied to the iterative process depending on which part of the model ISP is desired to be trained. The learning rate may be changed by the user prior to or during training. The ability to customise the learning rate for each portion of the model ISP allows the iterative process in which the increments are made, to converge better to the global minimum of the error and thus more accurately refine the modules of the model ISP. It should be understood that other optimisation hyperparameters (including learning rate) may be used and be different for different modules, parameters within one module, and/or phases of training.

The training method may also include additional steps when there is a second module to be trained after the first module. The second module of the model ISP may be trained to perform a second image signal processing function different from the image signal processing function of the first module. In the same way as with the first module, the second module is trained independently from the first module and thus while the second module is being trained, the first module is not being trained or may not be present at all. The second module is then trained by performing the same iterative steps as the first module and comparing the reference image 11 to a processed image 15 as discussed above. Inputting, to the model ISP, a second degraded image or batch of degraded images that represents a second known degradation of one or more reference images. The second degraded image may be degraded by the capture model in a different way from the first degraded image as it will be used to train a different module. For example, if the first degraded image was used to train the denoising module, noise would have been added, whereas the second degraded image may be used to train the sharpening module and therefore a blurring effect may have been added. The same reference image may be used for the degradation, or a different reference image may be used, e.g., if by doing so the degradation can be more easily realised or measured.

Once the second degraded image has been input, it may then be processed (e.g., "corrected", "refined") using the second module to perform a second image signal processing function. For example, in the case that the second module is a sharpening module, the second image signal processing function may be a sharpening function or deblurring function. This second image signal processing function when performed on the second degraded image, produces a second processed image. This second processed image is similar to the first processed image but different in that the property of the second module has been corrected e.g., the sharpness.

The second processed image is then compared to the reference image and an error is calculated between the two. In the example of the sharpening module the error may be the amount of blur that remains in the second processed image. The error that is calculated may then be used to update the second image processing function in a similar way as the first image processing function was updated as described above.

The training of the second module may occur either before or after the training of the first module but not at the same time (unless multiple GPUs are used, each GPU training a separate module). In this way each module can be individually refined without altering the other and without wrongly compensating for effects caused by the other modules. For example, when training the sharpening module, the trained demosaicing module (if one is present) may be enabled but the parameters are not updated during the updating step. In addition, when training the sharpening module, the degraded images, produced by the capture model may include a lens blur simulation and a colour filter array simulation. The same is true when training the denoising module, that both the noise simulation and the colour filter array may be enabled in the capture model and both the demosaicing module and the denoising module may be activated in the model ISP. Alternatively, the second module may be trained in isolation from the other modules such that the model ISP only includes the second module to be trained. Said second module once trained may then be combined with the first module to form a model ISP comprising both the first and second modules.

In addition, and optionally, to individually and separately training each of the modules of the model ISP, the model ISP as a whole may be trained after each module has been individually trained. This allows for a further refinement of the model ISP as a whole and may be thought of as fine tuning. In this case, the training method may include the further step of training both of the at least two modules (and other modules, if any, in the model ISP) simultaneously by performing minor adjustments that aid the modules in working better together as a coherent pipeline. This is achieved by first receiving one or more reference images in the same was as for training both the first and second modules.

The training method of this example then includes iteratively inputting to the first module of the model ISP, a third degraded image signal that represents a known degradation of the reference image. Unlike the first and second degraded image signals, the third degraded image signal may not only include a subset of functions of the capture model, e.g., only added noise or only added blurring, but may be an image that is degraded in all aspects modelled by the capture model, for example the combination of noise, blurring and CFA simulation, after being processed by the capture model.

The first module of the model ISP may then process the third degraded image signal by performing the base image signal processing function to produce a first processed image signal. This correction by the first module is the same as that performed in the training of the first module as the same function is performed, the difference being that the degraded image on which the function is performed is different. An example of the first module correction may be a denoising module providing a denoising correction.

The first processed image signal is then input into the second module in the pipeline of the ISP, which processes the first processed image signal by performing a second image signal processing function. This produces a third processed image that has been processed by both the first module and the second module. An example of the second module correction may be a sharpening module that performs a sharpening/deblurring correction. Once the first and second modules have performed their processing, and the third processed image has been produced by the second module, an error is calculated between the third processed image and the reference image by comparing the third processed image to the reference image. This is done in a similar manner as when training the first and second modules individually, however, the error will be calculated in consideration of all properties of the processed and reference images. The third processed image may be thought of as a composite corrected image that incorporates the corrections performed by the first module and the second module.

Once the error between the third processed image and the reference image has been calculated it is then used to update the first and/or second image processing functions performed by the respective first and/or second modules. This may include updating the first and/or second image processing functions by a second amount per iteration based on at least one second pre-set learning rate that is smaller than the first pre-set learning rate. The second pre-set learning rate may be an order of magnitude less than the first pre-set learning rate. This allows for the fine tuning of the model ISP pipeline as a whole while ensuring that only small changes are made to each module. In other words, an advantage of using a second learning rate that is small compared to the first learning rate is that it allows modularity to be preserved since the incremental changes caused by the second learning rate will not substantially change the function of the module set by the first learning rate and thus will not negate the training of the module in question. Since the modularity is preserved it remains possible for the user to determine which modules are introducing artefacts in the resulting output. This ensures that there is debuggability and that it is easy to make changes to the jointly trained network, e.g., by replacing the problematic module. In addition, this orthogonality also gives the user confidence that the trained model is close to the global minimum. Therefore, in summary, this achieves the effect of refining the model ISP further without compromising the modularity achieved by individual training of each module that was previously performed. Furthermore, because the at least one second pre-set learning rate is an order of magnitude less than the first pre-set learning rate, it is possible to fine tune the ISP such that the processing reaches a global minimum of image correction and does not move far away from the best correction with each iteration. In this way the fine tuning achieves the best image processing possible and returns the degraded image signal as close as possible to the reference image signal. This fine tuning further ensures that the modules of the model ISP are working synergistically. This approach works because the model ISP of this disclosure is designed to be approximately orthogonal, in the sense that the tasks of the modules are well-defined and do not overlap. Fine-tuning performs minor adjustments to make the model ISP work well as a whole.

The fine-tuning iterative process may continue until the calculated error is less than a threshold. This threshold may be set by the user in advance or may be computer generated automatically. One example of such a threshold may be the average pixel difference of a chosen property between the second corrected image signal and the reference image signal. The chosen property may be a single property or a property that considers multiple aspects of the image, for example a value that represents a measure of how close each pixel is as a whole to the same pixel in the reference image signal.

In some cases, the parameters of the first and/or second module may be trained as part of the training method by using a numerical optimiser (Adam optimiser) based on the gradient descent and/or back propagation of the error. Such optimisers are well understood in the context of training neural networks and may be accelerated using available software tools (e.g., deep learning frameworks such as PyTorch or TensorFlow) and hardware (e.g., GPUs). This allows each module to be trained in hours and not weeks, as would be the case in a conventional hardware-implemented ISP requiring manual tuning.

The at least two modules, e.g., the first and second modules, may be any two of a demosaicing module, a sharpening module, a black-level subtraction module, a spatial denoiser module, a global tone mapping module, a channel gain module, or an automatic white balance and colour correction module. If one of the modules includes a demosaicing module, then this module may be the first module to be trained since it may be required for training other modules (with its parameters frozen).

Once the model ISP has been trained as discussed in the training method above, the final step is to implement it on an NNA (or other inference device) and use the NNA to process images captured by the image capturing apparatus that the capture model imitates. If the capture model has been constructed correctly, the image capturing apparatus characterised correctly, and the training of the model ISP performed correctly, then the final processed image produced by the NNA will be an accurate representation of the scene prior to being captured by the image capturing apparatus.

As briefly described above, a module may be composed of a simple image processing algorithm (referred to as the "base image processing function") for performing the task of that module, and a refinement function for refining the output of the base image processing function. In some examples, the base image processing function will be a simple handcrafted function, with the refinement function performed by a (small) neural network. Since the base image processing function and the refinement function together comprise the module, and since they can be trained together in isolation from other modules of the differentiable model ISP, modularity is not violated. The aforementioned advantages of modularity (debuggability, explainability etc) are retained. Furthermore, each of the base processing function and/or the refinement function are differentiable, thus allowing the module as a whole to be differentiable. The advantages of designing a module in this way are: computational efficiency, since the handcrafted function gives correct results for the majority of the image, only requiring correction by a relatively simple network in difficult cases; visual quality, since the neural network will often exceed the quality of even highly complex handcrafted algorithms; efficient execution on the NNA in terms of power, bandwidth and inference time, since the target hardware is specialised to neural networks, and a simple handcrafted algorithm can often be implemented in a straightforward manner on such hardware; and vastly reduced development time, since a neural network is easier to develop and optimise than a handcrafted algorithm of equivalent quality. In summary, the advantages afforded by both neural networks (quality, development time) and handcrafted algorithms (computational and executional efficiency) are available in this approach. An example of this can be seen in figure 5 in relation to the demosaicing module, described now.

During the image capture process, the colour filter array (CFA, e.g., Bayer pattern) only transmits light frequencies corresponding to a particular passband of the colour filter, causing a single value to be recorded at each pixel depending on the passband of the colour filter, from incident light that may contain a full spectrum of colours. However, a full colour image requires three values for each pixel, corresponding to red, green and blue in the most common case. A demosaicing module is therefore typically included in an ISP to invert this sparse sampling process by filling in the gaps based on context to recover a full colour image. Since demosaicing is a challenging procedure, particularly in the presence of sharp edges or high-frequency patterns (especially where these exceed the Nyquist frequency of the sampling grid and therefore introduce aliasing), the demosaicing module of the model ISP of the present disclosure may be configured to perform a base bilinear demosaicing function, which may then be supplemented, for example by a convolutional neural network. A bilinear demosaicing function interpolates a value for each pixel lacking a value in a certain colour channel by taking the average of the values in that colour channel of the pixels surrounding the pixel in question. This approach of using a small neural network to correct the shortcomings of a simple algorithm, in place of a complex hand-engineered module, saves engineering and deployment time without violating the principles of modular design as described above.

This approach will now be described with reference to figure 5, which demonstrates both the additional refinement function configuration but also how such a module of the model is trained. If a demosaicing module is part of the model ISP pipeline, then this may be trained before other modules, such as the denoising module discussed later in relation to figure 6. In such a case all aspects of the capture model 12, except the colour filter array (CFA) simulation may be disabled and then the demosaicing module is trained as discussed below, with the exception that while the training of the demosaicing module takes place the training of other components (modules) of the model ISP implemented on the inference device (NNA) may be disabled. This is to prevent, say, a particular lens blur from impacting on the behaviour of the demosaicing module. The demosaicing module may be trained first when it is present because it generates the output image signal of the correct shape and number of channels, which allows the autoencoder approach to be used to train other modules with the demosaicing module in place (with its parameters frozen). In other words, without a demosaicer, the input or output of the module being trained may be in the wrong format, e.g. Bayer instead of RGB. After the demosaicing module has been trained and its parameters frozen, the other modules of the NNA may be trained as discussed generally above. In the example in figure 5, the base image processing function is a bilinear demosaicing function that performs a base refinement of the image signal. The base bilinear demosaicing function attempts to interpolate gaps caused by the capture model's simulation of the Bayer filtered 501 image/scene (reference image) 500. In this example, the base image processing function is a bilinear demosaicing function 503. The base bilinear demosaicing function 503 provides a base level of reconstruction of the simulated Bayer filter captured image (degraded image) 502, which is imperfect/corrupted during capture. An example may be that the bilinear demosaicer 503 may perform the vast majority of the refinement of the image, by performing the simple base image processing function. In this example, degradation will be most visible at sharp edges and where high frequencies are present in the input image 500. This refinement alone may not be acceptable, and as such it may be beneficial to supplement this refinement using a small neural network 504, which is an example of a refinement function.

Therefore, in addition to the base image processing function 503, one or more of the modules of the model ISP may also include a neural network (e.g. the demosaicing module of figure 5 includes a refinement function 504 that may be a neural network in addition to the bilinear demosaicer 503). This refinement function 504 functions alongside, i.e. parallel to, the base processing function performed by the module. Each neural network may be specific to the function to be performed, for example in figure 5 the refinement function 504 is a neural network (NN) for the purpose of correcting the output of the bilinear demosaicer 503. The refinement function 504 may supplement the refinement of the module's base image processing function to achieve a quality threshold that is deemed acceptable. The neural network that may be contained within at least one of the modules may be specific to the function of the module and the base image processing algorithm, the output of which it refines. In other words, the architecture of the neural network is designed for the task performed by the module. The final image for that module may then be output. Because the refinement function 504 is further refining/correcting the image from a base correction/refinement level produced by the module, the processing required to produce an output of sufficient quality is reduced compared to the case in which the refinement function 504 performed the complete process itself. In the configuration shown in figure 5, the output of the bilinear demosaicer 503 is combined with the output of the refinement function 504, in this case by addition. In such a configuration, the refinement function 504 may be considered to be correcting for the errors in the output of the bilinear demosaicer.

$$y = a(x) - e_a \qquad y \approx a(x) + b(x) \qquad \text{therefore} \qquad b(x) \approx -e_a$$

Here, $y$ is the reference image 500, x is the degraded image 502, $a(x)$ is the output of the bilinear demosaicer 503, $b(x)$ is the output of the refinement function 504, and $e_a$ is the error in the output of $a(x)$ with respect to the reference image 500. When training this module, the refinement function 504 is therefore being trained to approximate the negative error of the base image processing function. It will be appreciated that this parallel configuration of the base image processing function and refinement function is given by way of example only, and that other examples, including but not limited to a serial configuration, are possible. The model ISP thus designed to be differentiable to ensure backpropagation is supported for training of the modules and the pipeline and therefore It is important that the inclusion of a small neural network in a module does not violate modularity by introducing the disadvantages of undifferentiated neural networks enumerated above. Modularity is not violated in the configuration of this disclosure, in which the small neural networks are separately present in each module in parallel with the base image processing functions, and independently trainable of each other.

The refinement required of the refinement function 504 is made substantially easier than if it were to correct the input without the aid of the base image processing function performed by the module. In turn, this results in reduced cost (in terms of e.g., inference time, power and bandwidth) of the refinement function 504 used to perform the remaining correction/refinement. Figure 5 also shows the error 506 between the initial reference image 500 and the output corrected image 505. This is important for the training of the module as described above. Generally, the demosaicer is trained in a similar way to the denoising and sharpening modules, the difference being that the degraded image is produced using a simulation of a Bayer filter or the like, or a degraded image that exhibits the same properties as if it were degraded by a Bayer filter.

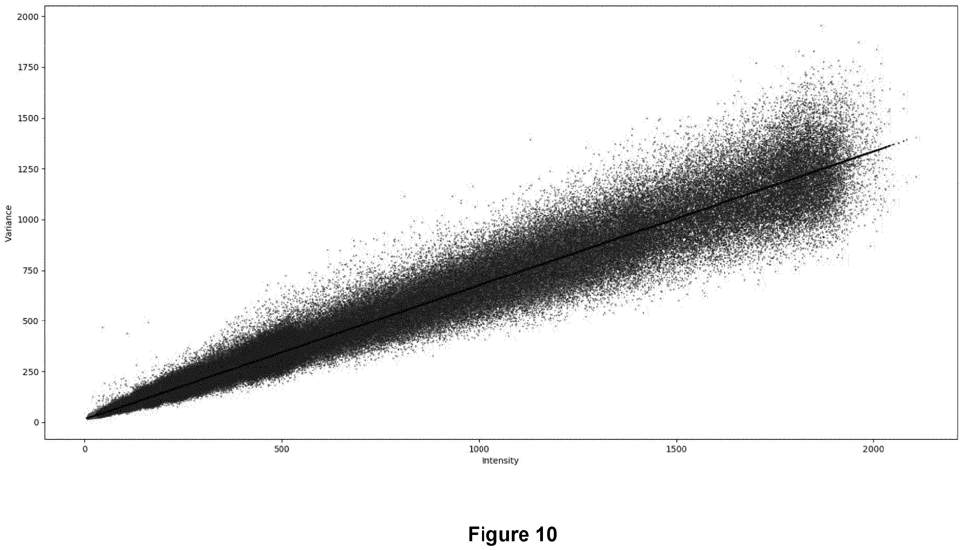

Figure 6 shows how the denoising module may be trained. An image/scene (reference image) 600 may be input to a capture process 601 that in the case of training the denoiser module may contain at least a function adding noise to the image to introduce a corruption. This corruption may for example be adding Poisson noise to the image. Applications of this method will match the noise model and its parameters to the statistics of the stochastic physical processes occurring during image capture in a real camera. The variance of the Poisson noise is directly proportional to the intensity of the (real) pixel, where the constant of proportionality is the gain, which relationship is shown in the case of data captured under controlled conditions in figure 10. This produces a degraded image 602 that has at least a noise component. The degraded image 602 is then input to the model ISP that, in this example, includes at least a denoising module. The denoising module may refine the degraded image using a bilateral filter with inputs 604. In this case the learnable (trained) parameter may be modulated by a gain as discussed below. Optionally, a small neural network may also be included in the denoising module to supplement the refinement performed by a base denoising function, such as a bilateral filter. This refinement produces a processed image 605 that has reduced noise. The processed image 605 is then compared to the reference image to calculate an error 606. The error is used to adjust iteratively the input parameters 604 of the base denoising function (e.g. the range variance of a bilateral filter), and if present the parameters of the small refinement neural network, to minimise the loss given by the difference between the denoised (processed) image and the reference image.

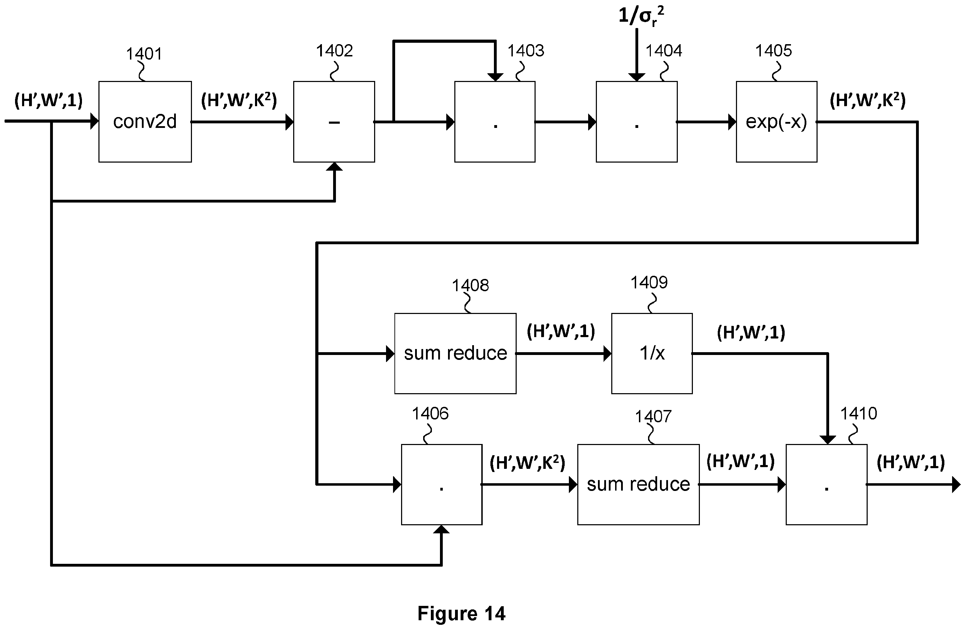

By way of example, Figure 14 shows a neural network that could be used for the bilateral filter 603. In this example, the bilateral filter operates on an image captured with a Bayer (or similar) mosaic pattern. Execution proceeds by first splitting the input image signal into component images of the same colour. For example, an $RG_1G_2B$ Bayer pattern is first split into separate R, $G_1$, $G_2$ and B component images. Each component image is denoised separately according to the method now described with reference to Figure 14, before being recombined into a denoised Bayer image. A given component image has height H' and width W' of H/2 and W/2, where H and W are the height and width of the degraded input image 602 respectively. The dimensions of a tensor containing this image can be represented as (H',W',1), where 1 corresponds to the channel dimension. A convolution operation 1401 is performed on this input tensor, yielding a tensor with $K^2$ channels, where the convolution kernel applied has dimensions $(K,K,1,K^2)$, and where the dimensions correspond to kernel height, kernel width, input channels and output channels respectively. The weights of this kernel are fixed (i.e. they are not trainable), and each output channel contains an offset delta function following this pattern in the case where K=3 (kernels for other values of K are defined similarly):

$$
\begin{array}{ccc}
1 \quad 0 \quad 0 \\
0 \quad 0 \quad 0 \\
0 \quad 0 \quad 0
\end{array}
\quad
\begin{array}{ccc}
0 \quad 1 \quad 0 \\
0 \quad 0 \quad 0 \\
0 \quad 0 \quad 0
\end{array}
\quad
\begin{array}{ccc}
0 \quad 0 \quad 1 \\
0 \quad 0 \quad 0 \\
0 \quad 0 \quad 0
\end{array}
\quad \cdots \quad
\begin{array}{ccc}
0 \quad 0 \quad 0 \\
0 \quad 0 \quad 0 \\
0 \quad 0 \quad 1
\end{array}
$$

When convolved with the input tensor, this results in a tensor in which the values in the channels at a given location correspond to the values in a corresponding input window centred on that same point in the input tensor. The next steps are to subtract 1402 the input values from this tensor (with broadcasting across channels), square it 1403, and multiply by the reciprocal of the learned range variance parameter $\sigma_r^2$ 1404. Steps 1402, 1403, 1404, 1406 and 1410 may be performed on elementwise operation hardware 2006 of an NNA when deploying a trained model ISP. A function 1405 implementing the exponential of the negative of the input is then applied, which at deployment may be performed on an activation unit 2004 of an NNA.

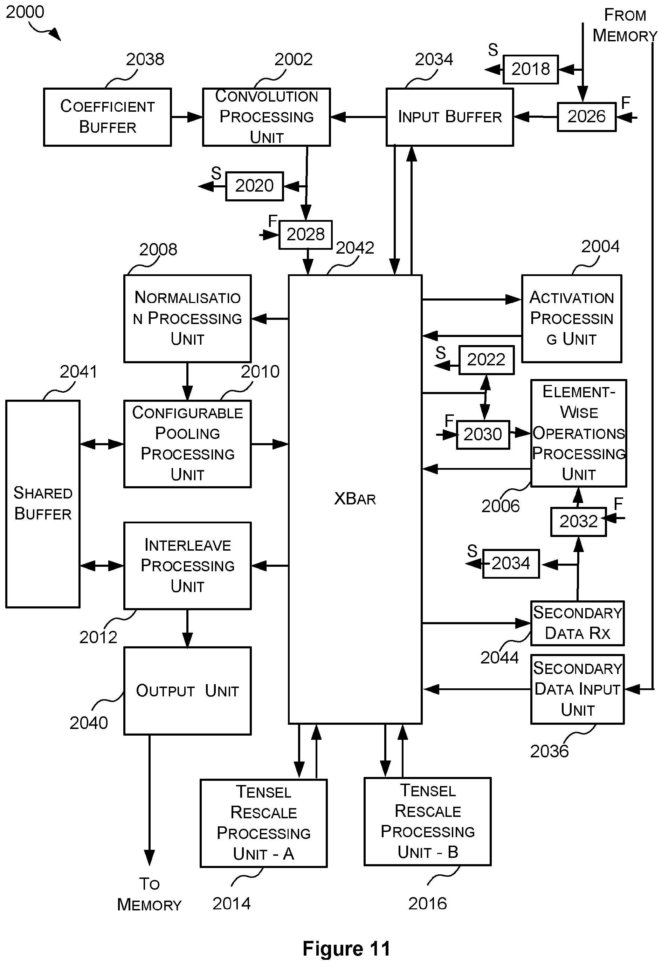

By the output of 1405, the function $w_{a,b} = \exp\left(-\frac{(x_a - x_b)^2}{\sigma_r^2}\right)$ has been implemented. We omit the spatial term for performance reasons. The remainder of the graph in Figure 14 implements the function $y_a = \frac{\sum_{b \in W_a} x_b w_{a,b}}{\sum_{b \in W_a} w_{a,b}}$. The output of 1405 is multiplied 1406 by the input component image, and the $K^2$ channels are summed together 1407 to yield a tensor with single channel, corresponding to the numerator $\sum_{b \in W_a} x_b w_{a,b}$. The $K^2$ channels of the output of 1405 are separately summed together 1408 to yield a tensor with a single channel, corresponding to the denominator $\sum_{b \in W_a} w_{a,b}$. Finally, to implement the division of the numerator by denominator, the output of 1408 is processed by a reciprocal function 1409, which at deployment may be performed on an activation unit 2004 of an NNA, and the output of the application of the bilateral filter to the component image is yielded by a multiplication operation 1410. The cross-channel summations 1407 and 1408 may be performed by convolutions with kernel of dimensions (1, 1, $K^2$, 1), with all weights fixed to 1 (i.e. not trainable). The entire bilateral denoiser is implemented in terms of neural network operations as described, which facilitates processing by a training apparatus and deployment on a suitable device, such as the example NNA 2000 of Figure 11.

Returning to Figure 6, the denoising module (that may be referred to herein as a spatial denoiser) may also form part of the model ISP pipeline implemented as part of the command stream on the inference device of the present disclosure. The spatial denoiser module may be implemented by the model ISP to remove the stochastic noise introduced during the capture process, e.g., when capturing photons of incoming light with the sensor (shot noise), spurious capture events caused by thermal radiation in the infrared (thermal background noise), or noise intrinsic to the analogue electronic components. The spatial denoiser may be configured to receive an image and apply a denoising function or spatial kernel to reduce the noise present in the image. This may be done using a simple bilateral filter or other similar image processing function. A bilateral filter may use a single parameter in order to govern the strength of the denoising, modulated by the total gain applied to each pixel (since the noise strength in the image on the input to the denoiser is governed by the gain applied). The spatial denoiser 204 of the present disclosure may therefore take as an input the total gain.

An ideal denoiser will preserve the structure (e.g., edges and features) of an image, whilst removing noise. The "bilateral filter", which is well known in the art, is a relatively simple and effective means of achieving this. The bilateral filter has the following form when expressed as an equation:

$$y_a = \frac{\sum_{b \in W_a} x_b w_{a,b}}{\sum_{b \in W_a} w_{a,b}} \qquad \text{where} \qquad w_{a,b} = \exp\left(-\frac{\|a - b\|_2^2}{\sigma_s^2}\right) \exp\left(-\frac{(x_a - x_b)^2}{\sigma_r^2}\right)$$

$W_a$ is a window centred on pixel location $a$, and b is pixel location from within the window $W_a$. $x_b$ is the intensity of a pixel from the input image at pixel location $b$, and $y_a$ is the intensity of a pixel from the output image at pixel location $a$.

The terms $\exp\left(-\frac{\|a - b\|_2^2}{\sigma_s^2}\right)$ and $\left(-\frac{(x_a - x_b)^2}{\sigma_r^2}\right)$ may be referred to as the spatial and range terms respectively, the strength of which are governed by the spatial and range variance parameters $\sigma_s^2$ and $\sigma_r^2$ respectively. These parameters may be chosen for example by training the bilateral filter as described below. In some cases, the spatial term may be omitted, and the gain $k$ of the original image incorporated into the range variance, for example as $\sigma_r^2 = k\tilde{\sigma}_r^2$ where $\tilde{\sigma}_r^2$ is the trained parameter.

Where an image processing operation is definable in terms of differentiable functions, as it will be appreciated is the case for the bilateral filter with reference to the above formula, that operation may for example be implemented in a deep learning framework such as TensorFlow or PyTorch, and its free parameters (e.g. the range variance parameter 604) learned by applying conventional numerical optimisation algorithms, such as stochastic gradient descent by backpropagation of error. The image processing operation must be implementable on the target NNA, either as an existing hardware module, or as combinations of multiple hardware modules.

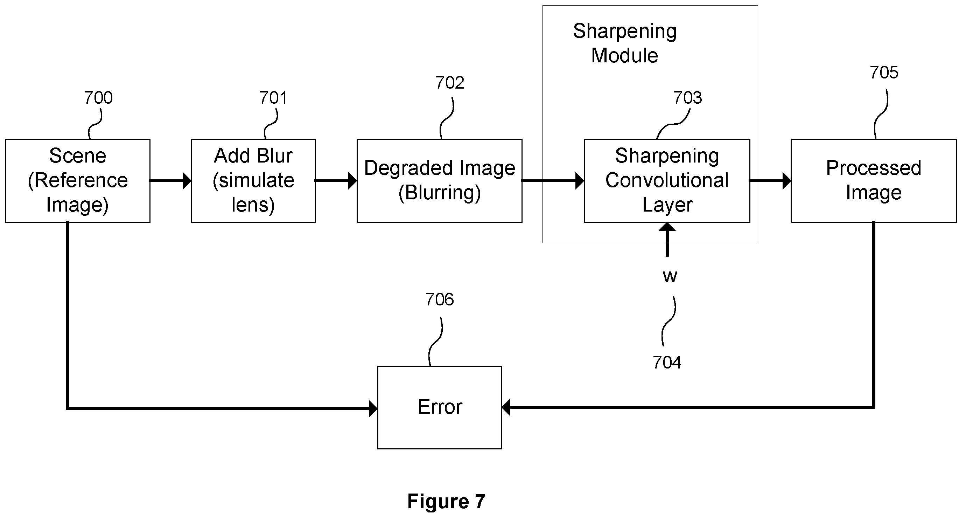

In the case of figure 7 the module in question is a sharpening module. As can be seen in figure 7, the sharpening module performs the function of sharpening in the model ISP pipeline, which inverts the corruption of the image due to blurring (usually by a lens) during a capture process. Figure 7 shows a scene 700 that is corrupted by the capture model 701. This corruption takes the form of a blurring component that is introduced as seen in 701 of figure 7 to produce a degraded image 702. The sharpening module of the model ISP that may be implemented as part of a command stream on the inference device (NNA) of the present example includes a base image processing function of refining the image using a convolution layer. This convolution layer may be a depthwise convolution comprising three input and output channels, in which the weights applied to each colour channel (e.g. red, green and blue) are shared between channels. The parameters of the convolution layer may be trained using conventional deep learning techniques, for example stochastic gradient descent with backpropagation of errors, where the error is defined with respect to the reference image 700 and the processed image 704. In this case, the weights will converge to a sharpening kernel that (approximately) inverts the blur kernel 701.

In the case of the sharpening module seen in figure 7, the module may perform a sharpening function using a single convolution as the base image processing function 703. This may be thought of as being either a simple neural network comprising one convolutional layer with a single input and output channel, or as a handcrafted function. If this convolution is 7x7 for example, then there are 49 parameters "w" to be learnt/trained. When considered as a handcrafted function, this is an instance of classical spatially invariant linear deconvolution for blurred image reconstruction. The parameters may all be trained simultaneously but might not be adjusted by the same amount or in the same direction, however they are trained so that they converge to a sharpening kernel which removes (or at least reduces) a given simulated lens blur. Note that this is only an example, and other more complex sharpening functions can be used (including independent per-channel kernels, spatially varying kernels, and small neural networks comprising multiple layers). Such more complex sharpening functions may be used where the blur function (i.e. the "point spread function") of the lens is spatially varying, and is different in different colour channels ("chromatic aberration").

The sharpening module may optionally include an additional refinement function such as a neural network (not shown), in the same way as the demosaicing module described above with reference to figure 5, that is configured to further refine the blurred image. This is a further example of a base image processing algorithm being augmented by a further algorithm performed by the base image processing function. The base image processing function and the refinement function may receive inputs "w" 704. These inputs may adapt the parameters of the base image processing function. The input "w" may also be used to adapt the parameters of a refinement function (neural network) that may be present in the sharpening module, however this is not shown in figure 7. Once the blurred image has been refined by the sharpening module, the sharpening module is configured to output the processed image 705 to the next module of the model ISP.

Figure 7 also shows how the sharpening module may be trained. In the same way as the other modules, a reference image 700 may be input into a capture model 701. The capture model (in this case shown as a single process to add blurring) 701, that may be used to train the sharpening module, includes at least processing the image, for example by simulating the effect of a lens on light from the scene, by introducing a blurring effect to the image. This blurring effect/corruption will be quantified and known based on the measured parameters/properties of a physical camera. Methods of measuring the parameters/properties of the capture model are described below in relation to sensor characterisation. The corruption introduced by blurring leads to a degraded image 702 being output by the capture process, which may be input to a model ISP pipeline that includes a sharpening module comprised of at least a base image processing function 703 that may include a sharpening convolutional layer. Once the degraded image 702 has been processed by the model ISP pipeline the degradation (corruption) of the image, in this case the blurring, produces a first processed image as described above. This first processed image 705 may be compared to the reference image in order to calculate an error 706 between the two. The error 706 is then used to refine the parameters within the sharpening module of the model ISP in order to produce a more accurate and refined processed image in subsequent iterations. This may be continued for any number of desired iterations or may continue until a refinement quality threshold is met, at which point the error 706 between the reference image and the processed image is sufficiently small.

The use of a capture model to corrupt a reference image is optional for training of each module. For example, in some cases at least one reference image and a corresponding degraded image with known properties may be used to perform training of the ISP modules without having to perform the degradation as part of the training process. It is important that a perfectly aligned pair of reference and degraded images are used to train each module.

Figure 8 shows an example of a model ISP implementable on an inference device (neural network accelerator (NNA)). The computational graph 800 depicts an example representation of a model ISP pipeline that may be implemented on an inference device (e.g., an NNA) that is configured to receive an image signal. This will then be the subject of the processing that is performed by the implementation of the model ISP on an NNA. An "image signal" may be raw sensor data that represents an image and may also include auxiliary data such as camera or sensor parameters (such as gain and black level), or other metadata. This may be a stream of raw sensor data that represents an image frame or raw sensor data that is held in a buffer until all the raw sensor data for an image frame has been received.

Each module shown in figure 8 performs a separate function and may be configured to receive inputs related to that function, for example, the black level subtraction module receives the black level as an input, shown by the arrow 809 input to the black level subtraction module. Each of these modules may receive a plurality of inputs relating to the respective task they perform. Each of the modules shown in figure 8 will now be described to explain how the model ISP 800 implemented on a neural network accelerator may reconstruct an image that has been corrupted by a capture process of a camera. Each of the modules may be implemented as separate and distinct modules of the model ISP 800. The model ISP is then converted to a command stream, at which point the modular nature of the model ISP is lost and the properties of the ISP are fixed. This is therefore only done once the model ISP is fully trained. Once the model ISP is converted to a command stream, the command stream can be implemented on an inference device, which in the case of the present disclosure is a NNA.

The model ISP may include a black level subtraction module 801 that is configured to receive an image signal (e.g., sensor data from a camera) and subtract from the image signal a baseline black level for each of the pixels within the image, thereby refining the image signal. This may be based on an input black level 809 that may represent a pixel value offset due to an underlying physical process such as dark current. The black level subtraction module may then output the refined image signal to the next module in the model ISP. The black level is typically a constant that may be measured for a given camera in a controlled capture (e.g. an exposure with no light incident at the sensor), or read from the manufacturer's documentation.

A channel gains module 802 may receive the refined image signal from the black level correction module 801, or other module, and further refine the captured image signal by accounting for the sensitivity of each pixel of the captured image. Different colour filters in the colour filter array (CFA) may transmit different fractions of light at different frequencies of the electromagnetic spectrum, which will typically manifest as a particular colour (e.g., blue) appearing darker than it should relative to other colours (e.g. green). In addition, the silicon that comprises the sensor itself has differing sensitivity to light at different frequencies (i.e. a photon capture event is more likely for photons of some frequencies than others). An indication of the sensitivity or, equivalently, the gain that should be applied to correct for the differences in sensitivity, may be input to the channel gains module 802 if the pixel sensitivity of the camera used in the capture process is known, otherwise this input may be a generic sensitivity level. For example, the channel gains module may correct the brightness of the three colour channels to counteract the sensitivity of the colour filter array. The sensitivities or appropriate channel gains for a given camera may be measured under controlled conditions, for example with reference to a test chart with calibrated colours.

The model ISP that may be implemented on the NNA of the present disclosure may also include a denoising module 803 described in relation to figure 6 and a demosaicing module 804 as described in relation to figure 5. The model ISP may also comprise a sharpening module 805 as described in relation to figure 7.

A colour correction module 806 and an automatic white balance module 807 may also be present and are configured to correct the colour and refine the white balance respectively. Colour correction may be performed by mixing the colour channels of the input image to match the human vision system based on a sensor colour profile corresponding to the sensor that captured the image. Automatic white balance may for example be performed with reference to the channel averages (e.g., implementing the white balance algorithm known in the art as "grey world").

The model ISP implemented on the NNA may also include a global tone mapping module 808 to perform global intensity manipulations such as gamma correction or histogram equalisation, which ensures that the image gives a correct or visually appealing output image when displayed. This may be achieved by refining the image through mapping the pixel levels from one dynamic range to another. This may be used to represent a high dynamic range input on a low dynamic range display, for example.

It should be understood that the model ISP of the present disclosure may include other suitable modules not described above and can be implemented on the NNA.

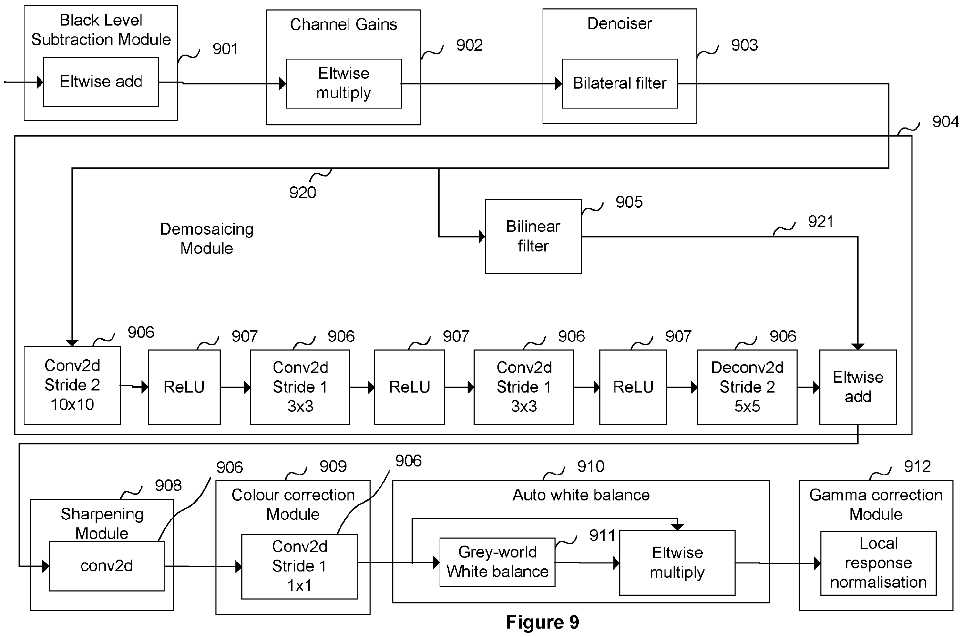

Figure 9 shows a further example computational graph that demonstrates a configuration that the pipeline of the model ISP implemented on the NNA of the current disclosure may take. In particular, figure 9 shows one example of a model ISP pipeline 700 that may be converted to a command stream that is used to configure the NNA. Figure 9 shows a model ISP as a differentiable computational graph at the level of its constituent primitive operations, and the boundaries between modules of the model ISP. These primitive operations are chosen to be implementable on the target NNA by means of a compilation or mapping process that converts the computational graph into executable machine code. It should be noted that, from the point of view of the compiler, the computational graph 900 appears as a neural network, although as described in detail above, it has important structure in its modular design and method of training which distinguish it from an undifferentiated neural network. Each primitive operation may act on the tensors that represent the image/image signal. For example, black level subtraction may be performed a single command for performing an elementwise add between the image input and a constant input representing the (negated) black level. These two commands form the black level subtraction module and may be considered in isolation from the other commands of the pipeline. In the model ISP of the present disclosure, these commands may be replaced or customised without materially altering the functioning of the other commands in the pipeline. The same can be said for each of the other modules shown in figure 9. Intermediate commands between the modules may also be included in the pipeline. These may perform simple conversions or transformations, for example changing the shape or size of the tensor output from one module and input to another. These intermediate commands are generally very simple in comparison to those within each module.

The example demosaicing module 904 shown in the example pipeline of figure 9 will now be further examined. The demosaicing module 904 shown in figure 9 has two branches 920, 921, each of which performs the function of a part of the module. The branch 921 may include a layer which performs a "space to depth" operation (not shown) arranging each 2x2 region of the Bayer image on the channel dimension, to output a tensor with half the height and half the width of the input, and 4 channels (RGGB). This allows easier processing using conventional convolution and transposed convolution operations. In the case of figure 9, the branch 921 performs the bilinear demosaicing function (the base image processing function 905), for example as a transposed convolution operation outputting a non-overlapping 2x2 quad of R, G and B pixel values, and branch 920 performs the refinement function. As can be seen in figure 9 the base image processing function performed by the branch 921 may be a relatively simple function, and may be a transposed convolution. The small neural network (refinement function) associated with the demosaicing module 904 shown on branch 920 of the demosaicing module 904 is a 4-layer convolutional neural network with Rectified Linear Unit (ReLU) 907 activations between convolutions 906. The convolutions 906 may be either standard convolutions or a transposed convolution (also known as "deconvolution" in the art, not to be confused with deconvolution in the context of removing blur), to return the convolved image signal to the original input resolution. As can be seen in the final step of the demosaicing module 904 shown in figure 9, the branch 921 and the branch 920 are then combined in an elementwise add layer, the output of which is the final output from the module 904. These functions are therefore executed as parallel branches within the module 904 (although when deployed on an inference device, these operations may be scheduled for execution in either a sequential or parallel manner). In the case of the demosaicing module 904, the neural network branch 920 refines the base demosaicing function (base image processing function) 921 to improve the quality of the image output by the module, in keeping with the principles described above with reference to figures 1 and 5.

The demosaicing module 904 shown in figure 9 then passes the output to a sharpening module comprising a 2D convolution and then in turn to a colour correction module 909 comprising a single 1x1 convolution layer implementing a matrix multiplication for each pixel, that performs a linear colour space manipulation to match, for example, the colours expected by a human viewer. In a similar manner to the black level subtraction module 901, the parameters (the colour conversion matrix) may be measured from a physical sensor under controlled capture conditions, and thus the parameters may be pre-defined rather than learned. The output of the colour correction module 909 feeds into the auto white balance 910 module, which in turn feeds into the gamma correction 912 module. None of modules 903, 908 and 909 include a refinement function in the example of figure 9, however the image/image signal may be divided/sliced between modules. This could allow differing chromatic aberrations in each colour channel to be corrected independently in modules such as the sharpening module 908, before concatenation back into a 3-channel image. Different parts of the image to be sharpened may be sharpened by different amounts before combining the refined sharpened images. In such a case concatenation step may be performed in the sharpening module 908. The final stage prior to outputting the final image in the example of figure 9 is gamma ($\gamma$) correction 912. To perform gamma correction the LRN (local response normalisation) hardware implements this function:

$$b_x = \frac{a_x}{(k + \gamma \sum_{y \in w_x} a_x^2)^\beta}$$

By setting $k$ to 0, $\gamma$ to 1 and the window size to 1, this simplifies to $b = a\text{^}(1\text{-}2^* \beta)$. Now, to raise to a to a power $p$, we set $p = 1\text{-}2^* \beta$, which gives us $\beta = (1\text{-}p)/2$. Since $\gamma$ correction is a power function, typically with $p=1/2.2$, we can substitute it into the formula and get $\beta = 0.273$. Using these parameters in the LRN hardware module on our NNA therefore results in a $\gamma$ correction function, as desired.

The blocks shown in figure 9 represent operations/commands performed by the module, while the arrows represent tensors. The one channel input to the model ISP is the monochrome raw image having one colour value per pixel location, e.g., either red, green or blue. The demosaicing module of figure 9 may be a 4-layer convolutional neural network with ReLU activations between convolutions. As an example, the neural network may include a first convolution which has a stride of 2 (to align with the 2x2 Bayer cells), and a kernel size of 10x10 with a single input channel of image signal tensor, and output an image signal tensor (at half resolution because of the stride of 2). The second convolution has a stride of 1, a kernel size of 3x3, and 32 output channels. The third convolution has the same properties as the second. The final convolution is a convolution transpose (a deconvolution) with a 5x5 kernel and a stride of 2 (taking it up to the original input resolution of the image signal), and 3 output channels (corresponding to RGB).

Each of the modules of the model ISP may comprise a series of parameters as part of either the base image processing function or the refinement function. These parameters may be adjusted during the training of each module as previously described.

Each of the at least two modules are trainable independently of the other modules. This is because each of the modules is functionally distinct from the others and thus each can be trained in isolation. The same is true of the operation of each module as each module will function in turn to process the image signal. In other words, the parameters (that may include weights) of each of the modules can be updated and refined during training. In some cases, some of the modules will not include learnable parameters, for example modules such as the colour correction, black level subtraction, grey world white balance and gamma correction modules.

An inference device, in some cases an NNA, may be configured to select and implement a model ISP from a series of model ISPs based on the requirements of the image processing needed. Each of the model ISPs that the inference device may implement may have a different configuration. In other words, each of the model ISPs may have a different pipeline of functional blocks and/or different sets of one or more parameters for the functional blocks of the pipeline. This may be by implementing as part of a pipeline one or more of the above-described modules that perform each functional block. In this way it is possible for the NNA of the present disclosure to implement a number of different model ISPs, each having different configurations. Each model ISP is converted to a command stream for implementation on the inference device of this disclosure. Once this conversion takes places the modularity of the model ISP is lost and thus this conversion is only performed when the model ISP has been completely trained. This allows different capture processes, possibly those of different cameras capturing images, to be inverted and accounted for. This could also allow the inference device to implement a model ISP that is specially configured to certain conditions (e.g. low lighting conditions) to be used when processing images that have been captured in those conditions. In addition, the inference device of the present disclosure may be implemented as hardware on a single silicon chip or as software on a single silicon chip. The model ISPs that the inference device selects from may be considered "virtual ISPs" and they may be implemented either concurrently or sequentially. For example, in order to process captured video in real time, a model ISP with a short processing time but lower-quality refinement could be run on the inference device at a high framerate. Conversely, a model ISP with a long processing time but that achieves a relatively high-quality level of image refinement could be run on the inference device occasionally for use processing still photographs. For single and multiple core neural network accelerators it is possible to time multiplex model ISPs to give the appearance of them running concurrently, Alternatively, if the neural network accelerator is comprised of multiple cores, then multiple model ISPs may be executed simultaneously on different cores.

Due to the modular configuration of the model ISP of the present disclosure, each module performing a set task of the ISP pipeline may be individually customised and refined in a different and separate manner as discussed above in relation to training. Not every module necessarily includes a refinement function (neural network), but certain modules can if so desired, e.g., the demosaicing module 510, 904 is shown in figures 5 and 9 as including a neural network but the sharpening module, or any other module may also include one. The neural networks associated with each module, along with parameters of handcrafted components such as basic image processing functions, may be independently customisable in order to provide the optimal refinement for that functional block of the model ISP. However, both the base image processing function and the refinement function are expressed as a single neural network in the deep learning framework used for training. In other words, both the base image processing function and the refinement function may be parts of a neural network performing different functions. This allows the functionality of each module to be trained and altered separately from others, either before or after being implemented on hardware, allows for easier tuning, and importantly preserves modularity. Furthermore, the model ISP can be updated after deployment on the NNA by updating parameters of the different modules and recompiling for that NNA.

Reference is now made to figure 11 which illustrates an example inference device, in this case an NNA, 2000 which can dynamically select and adjust the formats of network parameters while the NNA is performing a pass (e.g., a forward pass or a backward pass) of the neural network. The NNA may be configured to implement a command stream representing a differentiable model ISP as a combination of operations from a set of elementary neural network operations which are available on the inference device. The differentiable model ISP having a pipeline of separate (in some cases two or more) functional blocks. The set of elementary neural network operations consists of one or more of: a convolutional operation; a pooling operation; an element-wise operation; an activation operation; a local response normalisation operation; a tensor rescale operation; a channel permutation operation; a reshaping operation; a concatenation; reduction operations including sum, mean, minimise and maximise. The NNA 2000 comprises one or more network processing hardware units 2002, 2004, 2006, 2008, 2010, 2012, 2014, 2016, which are each configured to accelerate one or more neural network operations; one or more statistics collection hardware units 2018, 2020, 2022, 2024 which are each configured to dynamically collect one or more statistics on a set of network parameters for a layer of an artificial neural network (ANN) while the NNA is performing a pass of a neural network; and one or more format conversion hardware units 2026, 2028, 2030, 2032 which are configured to convert a set of network parameters to a configurable or selectable number format. The one or more statistics collected by a statistics collection hardware unit can be used to select a number format which can be applied to the set of network parameters from which the statistics were generated, another set of network parameters for the layer, or a set of network parameters in a subsequent pass of the neural network that are related to the original set of network parameters. This allows the number formats for one or more sets of network parameters to be selected and/or adjusted on the fly (i.e., while the NNA is performing a forward pass or a backward pass of the NNA).

As shown in figure 11, the NNA may also comprise one or more buffers or units 2034, 2036, 2038 for receiving data input to the NNA and/or an output unit 2040 for outputting data from the NNA. For example, the example NNA 2000 in figure 11 comprises an input buffer 2034 which is configured to receive and store input data received from memory, a secondary data input unit 2036 which is configured to receive input data received from memory, and a coefficient buffer 2038 which is configured to receive parameters (weights) for a convolution layer.

Each network processing hardware unit 2002, 2004, 2006, 2008, 2010, 2012, 2014, 2016, 2018 comprises hardware logic configured to accelerate performing one or more neural network operations on input data. Specifically, each network processing hardware unit 2002, 2004, 2006, 2008, 2010, 2012, 2014, 2016, is configured to receive input data, perform, using internal hardware logic, one or more operations on the received input data, and output the results of the one or more operations, which may be referred to as the output data. Since input data to a layer may be processed by multiple hardware processing units to generate output data for that layer, the input data to a hardware unit may or may not correspond to the input data to a layer, and the output data of a hardware unit may or may not correspond to the output data of a layer.

The example NNA 2000 of figure 11 comprises the following network processing hardware units: a convolution processing unit 2002 which comprises one or more convolution engines configured to perform convolution operations on the received input data, an activation processing unit 2004 which is configured to perform non-linear operations on the received input data, an element-wise operations processing unit 2006 which is configured to perform element-wise operations on the received input data, a normalisation processing unit 2008 which is configured to perform normalisation operations on the received input data, a configurable pooling processing unit 2010 which comprises one or more pooling engines configured to selective perform a pooling operation or a depth-wise convolution operation on the received input data, an interleave processing unit 2012 which is configured to performing interleaving or rearranging of the received input data, and tensel rescale processing units 2014, 2016 which are configured to scale or rescale the input data. Each of these network processing hardware units are described in more detail below. One or more of the network processing hardware units may be implemented as fixed-function circuitry. It will be evident to a person of skill in the art that this is just an example set of network processing hardware units and that other NNAs may have additional network processing hardware units, fewer network processing hardware units and/or different network processing hardware units.

The example NNA 2000 of figure 11 may be configured to perform a pass (e.g. a forward pass or a backward pass) of a NN over one or more hardware passes of the NNA. A hardware pass of the NNA is defined herein as the loading of input data into the NNA and processing the input data using one or more network processing hardware units to generate processed data, or output data, in the case of this disclosure a processed corrected image. The output data of a hardware pass may be output from the NNA to memory via the output unit 2040 or stored in the NNA for use in a subsequent hardware pass. The memory which is used to store the output data of a hardware pass may be memory that is external to the NNA, but is internal to the chip on which the NNA is situated (i.e., on-chip memory), or memory that is external to the NNA and is external to the chip on which the NNA is situated (i.e., off-chip memory).

The NNA may have hardware constraints (e.g., the size of the input buffer 2034, coefficient buffer 2038 and/or shared buffer 2041, number of convolution engines, number of pooling engines) that limit the processing that can be performed in a hardware pass, or the order in which, or number of times that, a hardware pass can use network processing hardware units. Where all of the processing to implement a neural network cannot be completed in a single hardware pass of the NNA 2000, the processing may have to be split into multiple hardware passes of the NNA 2000.

In some cases, the hardware passes to perform or implement a pass of a neural network may be identified by first mapping each layer of the neural network to a sequence of one or more low level layers, wherein a low level layer is a set of one or more operations that can be performed by a single hardware processing unit of the neural network accelerator. In other words, each low level layer corresponds to a hardware processing unit of the neural network accelerator. The low level layers that a layer is mapped to may depend on whether a forward pass or a backward pass is to be performed. For example, one set of operations may be used to implement or processed a forward pass of a layer of a neural network and a different set of operations may be used to implement or process a backward pass of that layer.

Once the layers of the neural network have been mapped to low level layers, the low level layers are divided into one or more layer groups, wherein each layer group comprises a sequence of one or more low level layers that can be implemented on the NNA 2000. The sequences of lower level layers that can be implemented by the NNA 2000 depend on the network processing hardware units of the NNA and how they can be connected to process data. For example, since the example NNA 2000 of figure 11 has a convolution processing unit and a configurable pooling processing unit that can be connected to form a pipeline, the NNA 2000 can perform convolution computations for a layer and pooling computations for a layer together. This means that a layer group may comprise a low level convolution layer followed by a low level pooling layer. In contrast, since the NNA 2000 comprises only a single configurable pooling processing unit it cannot perform pooling operations for two different low level layers. Therefore, in this example a layer group cannot comprise two pooling layers. In other words, since each low level layer corresponds to a hardware processing unit, each layer group comprises a sequence of hardware processing units that can be implemented by the neural network accelerator.

Once the low level layers have been split into one or more layer groups, it is determined, for each layer group, whether that layer group can be implemented in a single hardware pass of the neural network accelerator. Specifically, depending on the NNA hardware constraints, it may not be possible to perform all of the processing associated with a layer group in the same hardware pass. For example, the input tensor to the first layer of the layer group may be too large to be processed in a single hardware pass. Accordingly, if it is determined that a layer group cannot be implemented in a single hardware pass of the neural network that layer group is divided into a plurality of hardware passes. Dividing a layer group may comprising dividing the input tensor in one or more dimensions. For example, an input tensor may be split along one or more of the width, height, or input channel dimensions; and/or for a convolution layer, the convolution kernel may be split along one or more of the input channel dimension and the output channel dimension (which may also be referred to as the filter dimension). An example method for identifying hardware passes to perform a pass of a neural network is described in the Applicant's UK patent application no. 2209584.8, which is herein incorporated by reference in its entirety.

In the example NNA 2000 of figure 11 the network processing units are connected to a crossbar ("Xbar") 2042 which can connect, on a per hardware pass basis, a selected set of network processing hardware units in a selected order to form a pipeline of network processing hardware units through which the input data for the hardware pass is passed. Accordingly, at each hardware pass the NNA receives information indicating which network processing hardware units are active, and the order in which the active network processing hardware units are to process the input data. The crossbar 2042 then connects the input and output ports of the identified network processing hardware units accordingly. The crossbar 2042 may comprise a plurality of input ports (shown in figure 11 by arrows pointing into the crossbar 2042), and a plurality of output ports (shown in figure 11 by arrows pointing out from the crossbar 2042).

Having a crossbar 2042 that can dynamically connect the network processing hardware units in a plurality of different orders, increases the number of different layer combinations that can be in a layer group, compared to having fixed connections between the network processing hardware units. This can decrease the number of hardware passes to implement an ANN. However, it will be evident to a person of skill the art that this is just an example only and other NNAs may connect the network processing hardware units in another manner. For example, in other NNAs the network processing hardware units may be connected in a fixed order (e.g., to form a fixed pipeline).

To perform a pass of a neural network on a neural network accelerator, the network parameters are represented in a number format such as, but not limited to, a floating point number format or a fixed point number format. The term "network parameter" is used herein to mean any tensors or parts of tensors used in performing the pass of a neural network and include, but are not limited to, the input data values of a low level layer (which may or may not correspond to the input data values of a layers of the neural network), the output data values of a low level layer (which may or may not correspond to the output data values of a layer of the neural network), the parameters for a low level layer, and the biases for a low level layer. Since different low level layers may have different input and output value ranges it may not be efficient to use a single number format for all the network parameters. For example, one low level layer may have input data values between 0 and 6 whereas another low level layer may have input data values between 0 and 500. Accordingly, using a single number format may not allow either set of input data values to be represented efficiently or accurately. Therefore, the NNA 2000 comprises one or more format conversion hardware units 2026, 2028, 2030, 2032 which can dynamically convert a set of network parameters to a selected format. Specifically, each format conversion hardware unit 2026, 2028, 2030, 2032 is configured to: receive a set of network parameters; receive information identifying a desired number format (identified as "F" in figure 11); and dynamically convert the received set of network parameters to the desired number format. This allows number formats for network parameters to be selected and implemented on a per low level layer basis, and even on a per hardware pass basis for each low level layer.

Each statistics collection hardware unit 2018, 2020, 2022, 2024 is configured to receive a first set of network parameters input to or output from a unit of the NNA, and generate or collect one or more statistics (denoted "S" in figure 11) for that set of network parameters which can be used to select a number format in accordance with a format selection algorithm.

In addition to the neural network accelerator described above. This disclosure also provides a method of image processing using an inference device that is configured to implement a command stream representing a differentiable model ISP as a combination of operations from a set of elementary neural network operations which are available on the inference device. The differentiable model ISP having a pipeline of separate (in some cases two or more) functional blocks. The set of elementary neural network operations consists of one or more of: a convolutional operation; a pooling operation; an element-wise operation; an activation operation; a local response normalisation operation; a tensor rescale operation; a channel permutation operation; a reshaping operation; a concatenation; reduction operations including sum, mean, minimise and maximise.

. In the method of image processing an image signal may be processed using an inference device that is functioning as an ISP that prior to being converted into a command stream had at least a first module and a second module. This inference device (NNA) may be that described above or an alternate NNA. In processing the image signal, the inference device will perform the processing of each of the modules of the model ISP by implementing the command stream that represents the differentiable model ISP pipeline. In other words, the inference device will perform the image processing functions that are represented by each module of the model ISP, e.g., denoising, demosaicing, sharpening etc. However, such modules will be indistinguishable in the command stream and the command stream will represent the combined collective functionality of the ISP pipeline. The refinement, represented by the command stream, of the image signal will be performed until the image signal is fully refined and may be output after being processed by the inference device functioning as the ISP pipeline. The first module and/or the second module of the model ISP that is implemented on the inference device may be any of the modules described above, or a module performing an alternate function as known for image signal processing. The first and second modules may be the same or different from each other.

One or more of the at least two modules of the model ISP (that include the first and second modules of the model ISP) may comprise a base image processing function. In the case of the first and second modules described above, the first module may comprise a first base image processing function, and the second module may comprise a second base image processing function. Each of the first and second base image processing functions form part of implementing the first and second functional blocks of the model ISP respectively. These base image processing functions perform refinements of the image signal and may be implemented by logic of the command stream of an inference device.

[0154] , the method may include iteratively performing the first base image processing function and/or the second image processing function iteratively. In this scenario, the processing by the first and/or second module may form a loop around the module processing in order to further refine the image signal. The same may be achieved by forming a loop around the neural network if one is present within the module. Alternatively, each module as a whole may iteratively process the image signal passed to it, should this be desired. In this way, each of the modules may perform its respective image processing function on an image signal a plurality of times in a plurality of passes through the module.

The method of image processing of this disclosure may further include the step of selecting the image signal processor from a series or group of image signal processors that may be implementable on the inference device prior to performing the method described above.

As mentioned above, each of the modules of the differentiable model ISP that are used to perform the image processing method may have been trained independently or are trainable independently. This allows some modules to be refined while the others remain unchanged allowing for specific parts of the model ISP on the NNA to be trained in isolation. The ability to train the individual modules of the differentiable model ISP dramatically speeds up the training process as each module can be trained on a time scale of minutes as opposed to days or weeks that it would conventionally take to tune an ISP manually. The training of these modules may be achieved by updating the parameters of the base image processing function and/or the neural network. Such, parameters may include weights for the functions performed as well as other parameters.

Examples of sensor characterisation will now be described. In characterising a camera, characteristics such as the following may be used: channel sensitivities, colour confusion, dark noise (noise related to photon capture) and conversion gain (relationship between the "true" intensity of a pixel and the noise strength). When considering how to characterise the colour calibration, the responses of three Bayer colour filters will not be the same as the responses of the human vision system (HVS), based on the three types of cone cells in the human retina.

In order to perform colour calibration a test chart may be used that includes regions of pure colour, e.g., pure red, pure green and pure blue. These pure colours may be thought of as standard reference colours, and may for example correspond to certain colours in a given colour standard. The colours pure red (R), pure green (G) and pure blue (B) may be represented by the following unit vectors.

$$\text{pure red} = \begin{pmatrix} 1 \\ 0 \\ 0 \end{pmatrix} \qquad \text{pure green} = \begin{pmatrix} 0 \\ 1 \\ 0 \end{pmatrix} \qquad \text{pure blue} = \begin{pmatrix} 0 \\ 0 \\ 1 \end{pmatrix}$$

This means that in the absence of colour distortions (e.g., channel sensitivities and colour confusion), the pixels in the image of such a test chart will ideally be recorded by a sensor as being pure red, pure green and pure blue, up to a global scale factor. However, real-world sensors will record the colours differently ($R'$, $G'$, $B'$) from the pure colours ($R$, $G$, $B$) displayed and thus the recorded image will require a colour correction process to return the image of the test chart recorded by the sensor to the image of the test chart as seen by the HVS.

The reference scene is then captured with a camera ensuring that the image is in focus and the gain and exposure are set to the default values. The capture should be set up in such a way that external factors, such as lighting, do not alter the apparent colours of the red, green and blue blocks, and that none of the pixels are saturated. The red, green and blue intensities are then averaged for the nominally red, green and blue regions of the image. A mapping is then found between the [R', G', B'] colours recorded by the sensor, and the [R, G, B] colours of the HVS. That is, the parameters of a model are determined such that the average recorded colour of the red region is converted to pure red, the average recorded colour of the green region to pure green, and the average recorded colour of the blue region to pure blue. A simple offline demosaicing operation such as bilinear demosaicing may be applied to interpolate the recorded values, to find red, green and blue values for every pixel location to simplify the implementation of this process. To characterise the colour calibration a simplifying assumption may be made as known in the art, namely that the recorded colours are related to the pure colours by a linear mapping (i.e., they can be modelled by a multiplication by a matrix A). It will be appreciated that this is an example only, and other (perhaps more elaborate) models may be used. The red, green and blue intensities are then averaged for the nominally red, green and blue regions of the image. This results in the following vectors:

$$\begin{bmatrix} R'_r \\ R'_g \\ R'_b \end{bmatrix} \quad \begin{bmatrix} G'_r \\ G'_g \\ G'_b \end{bmatrix} \quad \begin{bmatrix} B'_r \\ B'_g \\ B'_b \end{bmatrix}$$

These correspond to the measured, apparent colours for the red, green and blue regions respectively. The matrix A mapping pure to recorded values is the concatenation of these vectors, as can be appreciated since it maps the pure colours in the reference scene (representable as unit vectors as described above) to the measured colours:

$$A \begin{bmatrix} 1 & 0 & 0 \\ 0 & 1 & 0 \\ 0 & 0 & 1 \end{bmatrix} = A = \begin{bmatrix} R'_r & R'_g & R'_b \\ G'_r & G'_g & G'_b \\ B'_r & B'_g & B'_b \end{bmatrix}$$

In further detail the above relationship is shown below.

$$A \begin{bmatrix} R \\ G \\ B \end{bmatrix} = \begin{bmatrix} R' \\ G' \\ B' \end{bmatrix}$$

The columns of matrix A are composed of the recorded red, green and blue colours given by the following expressions (whence the identity matrix in the above definition of A):

$$\begin{bmatrix} R'_r & R'_g & R'_b \\ G'_r & G'_g & G'_b \\ B'_r & B'_g & B'_b \end{bmatrix} \begin{bmatrix} 1 \\ 0 \\ 0 \end{bmatrix} = \begin{bmatrix} R'_r \\ G'_r \\ B'_r \end{bmatrix}$$

$$\begin{bmatrix} R'_r & R'_g & R'_b \\ G'_r & G'_g & G'_b \\ B'_r & B'_g & B'_b \end{bmatrix} \begin{bmatrix} 0 \\ 1 \\ 0 \end{bmatrix} = \begin{bmatrix} R'_g \\ G'_g \\ B'_g \end{bmatrix}$$

$$\begin{bmatrix} R'_r & R'_g & R'_b \\ G'_r & G'_g & G'_b \\ B'_r & B'_g & B'_b \end{bmatrix} \begin{bmatrix} 0 \\ 0 \\ 1 \end{bmatrix} = \begin{bmatrix} R'_b \\ G'_b \\ B'_b \end{bmatrix}$$

In other words, A can be constructed directly from the recorded colours. This relationship can then be inverted to find the matrix $A^{-1}$ which maps the recorded to the pure colours:

$$A^{-1} \begin{bmatrix} R' \\ G' \\ B' \end{bmatrix} = \begin{bmatrix} R \\ G \\ B \end{bmatrix}$$

As such, when $A^{-1}$ is applied to the recorded image the colours will be corrected to substantially match the pure colours.

When employed as part of the ISP, it is desirable to perform the above calibration in two discrete stages during the pipeline, in particular as part of a channel gains module and a colour correction module. To get the parameters for these modules, it is necessary to decompose matrix $A^{-1}$ into two matrices $M$ and $\lambda$, corresponding to colour correction and gains respectively. $M$ maintains the brightness of the channels (i.e., the rows will sum to 1) in a new normalised colour space, and $\lambda$ is a set of scale factors and is a diagonal matrix. The diagonal of lambda may be found by summing the rows of $A$. $\lambda$ applies scale factors independently to each channel, so is necessarily a diagonal matrix and thus takes the following form:

$$\lambda = \begin{bmatrix} \lambda_r^{\square} & 0 & 0 \\ 0 & \lambda_g^{\square} & 0 \\ 0 & 0 & \lambda_b^{\square} \end{bmatrix}$$

In further detail the factorisation is achieved by first summing the elements of each row of $A^{-1}$. This gives three values, corresponding to red, green and blue respectively. These values are the channel gains. These channel gains are the diagonal of the matrix $\lambda$. $M$ can then be found by dividing each row of the matrix $A^{-1}$ by the corresponding channel gain. This normalises the rows of the matrix $A^{-1}$ such that they each sum to 1, and results in the following expression:

$$A^{-1} \begin{bmatrix} R' \\ G' \\ B' \end{bmatrix} = M \lambda \begin{bmatrix} R' \\ G' \\ B' \end{bmatrix} = \begin{bmatrix} R \\ G \\ B \end{bmatrix}$$

A corresponding factorisation of the matrix $A$, as might for example be used in the capture model, can be found by inverting the colour correction matrix $M$ to produce a "colour confusion matrix". Similarly, the channel sensitivities can be found by inverting the channel gains matrix lambda e.g., $\lambda^{-1}$, or [1/ $\lambda_r$, 1/ $\lambda_g$, 1/ $\lambda_b$]. Furthermore, once lambda has been found, it is possible to apply a global scale factor to avoid altering the overall brightness of the image. For example, all values in $\lambda$ may be divided by the maximum value in $\lambda$. Lambda may instead be scaled by a different amount depending on the user's needs.

Regarding the capture setup, a synthetic image may be created, e.g., using image manipulation software. For example, the synthetic image may contain pure red, green and blue patches. For the purpose of the capture setup, the synthetic image may be displayed on a (ideally calibrated) computer monitor and captured with a camera. An advantage of displaying the image on a monitor is that the chart is emissive, which means that it is uniform and less prone to interference from other (coloured) light sources. This means it is possible to perform colour calibration with a relatively uncontrolled capture environment; however care should be taken to have no light shining on the monitor. As an example, the red patch, green patch and blue patch may be averaged to remove the influence of noise, to obtain the A matrix (the concatenation of these averages according to the above method). The $A$ matrix may be decomposed into a colour confusion matrix $M$ and a (rescaled) sensitivity matrix $\lambda$ according to the above method. The inverses of these can then be applied to an image captured by the sensor to check that that they perform the correction, e.g. by checking that the resultant image corresponds to the original synthetic image.

A black level of the sensor may be characterised by reducing the gain to the minimum value and taking a capture with the lens cap on, then averaging the measured pixel intensities.

The noise of the sensor may be modelled as having two components, "dark noise" which is assumed to have a fixed strength (variance) independent of exposure time or intensity, and photon capture noise. Photon capture may be modelled to a high degree of accuracy as a Poisson process, where the variance at each pixel is directly proportional to the true intensity. The constant of proportionality may be referred to as the "conversion gain" *k*. In order to measure the strength of the noise components, a number of captures may be taken. According to an example, 128 captures were taken with a static camera. For each pixel location, the mean and variance were calculated. The plot shown in figure 10 shows the mean intensity against variance, where the points are coloured by their location in the Bayer array (red corresponding to red pixel locations, etc). The noise model may then be fitted to these points with the expectation of a straight line with an offset.

$$\sigma^2 = \sigma^2_{\text{dark}} + \sigma^2_{\text{photon}}$$

$$\sigma^2 = \sigma^2_{\text{dark}} + kI$$

Where k is the gradient of the line and $\sigma^2_{\text{dark}}$ is the offset. A least-squares best fit may be applied in order to arrive at values for the two parameters of this statistical model.

The above exemplary methods may be used for, or as part of, camera characterisation. Once the properties of the camera have been characterised, the corresponding parameters of the capture model can be configured according to the characteristics of the camera, so that it may be used to simulate the action of that camera on input images.

In addition to the above-described training method for training the model ISP to function as an ISP, this disclosure also includes a training apparatus that is configured to perform the method discussed above. The training apparatus will now be described below.

The training apparatus of this disclosure is for training a differentiable model ISP, the image signal processor having a pipeline of separate image signal processing functions, wherein the differentiable model of the image signal processor comprises at least two differentiable modules, each of the differentiable modules of the differentiable model image signal processor being configured to perform a respective single image signal processing function of the pipeline. The training apparatus comprises one or more processors that are configured to train a first module of differentiable model ISP to perform a first image signal processing function, whilst not training other modules of the differentiable model ISP, by iteratively performing steps (S112 to S115) discussed above in relation to the training method of figure 4.

The one or more processors of the training apparatus may be configured to stop the iterative process when the error calculated in step S114 is less than a threshold. This threshold may be the same as described above in relation to the training method but configured to be registered by the one or more processors of the apparatus, which then stop the iterative process. The one or more processors may then output the corrected image signal of that iteration as the final corrected image signal or may convert the corrected image signal into an image that can be viewed on a display by the user.

In addition, the modules of the differentiable model ISP that are trained by the training apparatus of this disclosure may be configured as discussed above in relation to the model ISP. In other words, each module may comprise a base image processing function and a refinement function (refinement neural network). The one or more processors may be further configured to, in the updating step S115 discussed above, update one or more parameters of the first image processing function by a first amount per iteration based on at least one first pre-set learning rate. This is the same as in the training method described above. The first image processing function as discussed above may be formed of the base image processing function and the refinement function (refinement neural network), should a module include a refinement function. The term first image processing function may therefore be thought of as the general function of the module for example a denoising function in the case of the denoising module.

The one or more processors of the training apparatus of this disclosure may also be further configured to train a second module of the model ISP to perform a second image signal processing function different from the first image signal processing function, whilst not training other modules of the model ISP. The one or more processors may be configured to train the second module in substantially the same way as the first module and as discussed above in relation to the training of the second module in the training method. The training apparatus can be configured to train the second module sequentially to the first module. In other words, the one or more processors may be configured to train the second module either before or after the first module but not at the same time as/during the training of the first module. In this way it is possible for the training apparatus to train each module in isolation and refine only the image processing function of the respective module that is desired to be trained. This allows only parts/modules of the model ISP pipeline to be refined without altering the other parts/modules.

In some examples the one or more processors may be further configured to train both modules of the ISP simultaneously, e.g., once each of the modules has been trained independently. In this configuration the one or more processors are configured to receive a reference image. This reference image may be converted into a (reference) image signal for use in the training method. The one or more processors may be configured to perform the iterative process described above in relation to the training method. The iterative process is in this case that the third degraded image signal is input to the first module and is then processed by the first module to produce a first processed image signal. The first processed image signal is then input to the second module and is then processed to produce the third processed image. The processors are then configured to calculate an error between the third processed image and the reference image and update the first and/or second image processing functions performed by the respective first and/or second modules based on the calculated error.

The training apparatus, and more particularly the one or more processors may be further configured to fix the parameters of the first module or the second module that is not being trained while the other of the first or second module is trained. This allows each module to be trained separately by the apparatus. Furthermore, the one or more processors may also be configured to, when updating the parameters of the first and/or second image processing functions, do so by a second amount per iteration based on a second pre-set learning rate as described in the training method above.

In the above disclosure the first pre-set learning rate is effective at providing fast convergence to an approximate solution (optimal correction), but it may be beneficial when fine-tuning to reduce the learning rate (to the second pre-set learning rate) in order for the solution to converge to a true/real minimum. The reduction of the learning rate means that the changes to the parameters does not, after converging to a minimum, then diverge away from the desired solution.

The one or more processors of the training apparatus of this disclosure may also be configured to perform any of the functions described above in relation to the training method and the modules of the ISP, which is trained by the training apparatus may include any of the modules discussed above.

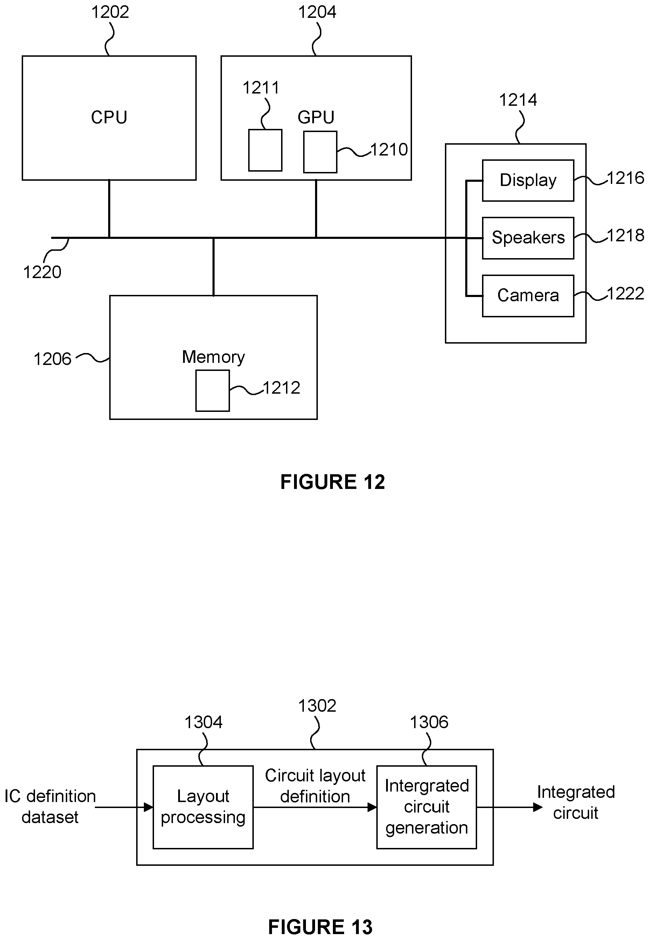

Figure 12 shows a computer system in which the graphics processing systems described herein may be implemented. The computer system comprises a CPU 1202, a GPU 1204, a memory 1206 and other devices 1214, such as a display 1216, speakers 1218 and a camera 1222. A processing block 1210 is implemented on the GPU 1204, as well as a neural network accelerator (NNA) 911. In other examples, the processing block 910 may be implemented on the CPU 1202 or within the NNA 1211. The NNA 1211 may be one of the NNAs as described above (e.g. the inference device). The training apparatus described above may be implemented on the processing block 1210. The components of the computer system can communicate with each other via a communications bus 1220. A store 1212 is implemented as part of the memory 1206.

While Fig. 12 illustrates one implementation of a graphics processing system, it will be understood that a similar block diagram could be drawn for an artificial intelligence accelerator system - for example, by replacing either the CPU 1202 or the GPU 1204 with a Neural Network Accelerator (NNA) 1211, or by adding the NNA as a separate unit. In such cases, again, the processing block 1210 can be implemented in the NNA.

The model ISPs of figure 2 are shown as comprising a number of modules each implementing a functional block. Each functional block may be provided in any suitable manner. It is to be understood that intermediate values described herein as being formed by an NNA need not be physically generated by the NNA at any point and may merely represent logical values which conveniently describe the processing performed by the NNA between its input and output.

The inference device and training apparatus described herein may be embodied in hardware on an integrated circuit. The inference device and training apparatus described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms (functions) and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture an inference device or training apparatus configured to perform any of the methods described herein, or to manufacture an inference device or training apparatus comprising any apparatus described herein. An integrated circuit definition dataset may be, for example, an integrated circuit description.

Therefore, there may be provided a method of manufacturing, at an integrated circuit manufacturing system, an inference device or training apparatus as described herein. Furthermore, there may be provided an integrated circuit definition dataset that, when processed in an integrated circuit manufacturing system, causes the method of manufacturing an NNA or training apparatus to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

An example of processing an integrated circuit definition dataset at an integrated circuit manufacturing system so as to configure the system to manufacture an inference device or training apparatus will now be described with respect to Figure 13.

Figure 13 shows an example of an integrated circuit (IC) manufacturing system 1302 which is configured to manufacture an inference device or a training apparatus as described in any of the examples herein. In particular, the IC manufacturing system 1302 comprises a layout processing system 1304 and an integrated circuit generation system 1306. The IC manufacturing system 1302 is configured to receive an IC definition dataset (e.g., defining an inference device or a training apparatus as described in any of the examples herein), process the IC definition dataset, and generate an IC according to the IC definition dataset (e.g. which embodies an inference device as described in any of the examples herein). The processing of the IC definition dataset configures the IC manufacturing system 1302 to manufacture an integrated circuit embodying an inference device or a training apparatus as described in any of the examples herein.

The layout processing system 1304 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g., in terms of logical components (e.g., NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 1304 has determined the circuit layout it may output a circuit layout definition to the IC generation system 1306. A circuit layout definition may be, for example, a circuit layout description.

The IC generation system 1306 generates an IC according to the circuit layout definition, as is known in the art. For example, the IC generation system 1306 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 1306 may be in the form of computer-readable code which the IC generation system 1006 can use to form a suitable mask for use in generating an IC.

The different processes performed by the IC manufacturing system 1302 may be implemented all in one location, e.g., by one party. Alternatively, the IC manufacturing system 1302 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture an NNA or a training apparatus without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g., by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 13 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 13, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, increased throughput, reduced execution time, and/or reduced power consumption. During manufacture of such devices, apparatus, modules, and systems (e.g., in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget. (It will be appreciated that an ISP can perform other, aesthetic functions not strictly related to image reconstruction, for example "over-sharpening" an image to make it look crisp.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

**Claims**

1. A differentiable module of a differentiable model of an image signal processor, the image signal processor comprising a pipeline of functional blocks, wherein the differentiable module is configured to implement a single functional block of the pipeline, the differentiable module comprising:

    base logic configured to receive an input image signal and to process the received input image signal by performing a base image processing function that represents a task of the functional block of the pipeline implemented by the module;
    a refinement function configured to receive the input image signal and to process the received input image signal in parallel to the processing of the received input image signal by the base logic; and
    combining logic configured to combine the processed image signal from the base logic and the processed image signal from the refinement function to determine an output image signal to be outputted from the differentiable module.

2. The differentiable module of claim 1, wherein the differentiable module is representable with a command stream as a combination of operations from a set of elementary neural network operations which are available on an inference device, for implementation on the inference device; and
   wherein the set of elementary neural network operations consists of one or more of:

a convolutional operation;
a pooling operation;
an element-wise operation;
an activation operation;
a local response normalisation operation;
a tensor rescale operation;
a channel permutation operation; and
a reshaping operation.

3. The differentiable module of any preceding claim wherein the base image processing function that the logic of the differentiable module is configured to perform is a function that, when applied to an image signal, refines the image signal in one regard.

4. The differentiable module according to claim 3, wherein the refinement function is configured to supplement the refinement performed by the base image processing function.

5. The differentiable module according to claim 4, wherein in supplementing the refinement performed by the base image processing function the refinement function is configured to process the input image signal in a manner such that the combining logic corrects an error remaining in the processed image signal after the base logic has processed the received input image signal.

6. The differentiable module according to any preceding claim, wherein the differentiable module is any of a demosaicing module, a sharpener module, a black-level subtraction module, a spatial denoiser module, a global tone mapping module, a channel gain module, an automatic white balance, or a colour correction module.

7. An inference device for image processing, the inference device configured to implement a command stream representing a differentiable model of an image signal processor as a combination of operations from a set of elementary neural network operations which are available on the inference device, the image signal processor having a pipeline of two or more functional blocks, the differentiable model of the image signal processor comprising:
   at least two differentiable modules, each of the at least two differentiable modules configured according to any one of claims 1 to 6.

8. A method of processing an image signal using an inference device which is configured to implement a command stream representing a differentiable model of an image signal processor, the image signal processor having a pipeline of functional blocks, wherein the model of the image signal processor comprises a differentiable module configured to implement a single functional block of the pipeline, the method comprising:

   receiving an input image signal at the differentiable module;
   processing the received input image signal by performing a base image processing function that represents a task of the functional block of the pipeline implemented by the module;
   processing the received input image signal using a refinement in parallel to said processing the received input image signal by performing a base image processing function;
   combining the processed image signal from performing the base image processing function and the processed image signal from using the refinement function to determine an output image signal; and
   outputting the determined output image signal from the differentiable module.

9. The method of claim 8, wherein the command stream represents the differentiable model of the image signal processor as a combination of operations from a set of elementary neural network operations which are available on the inference device; and
   wherein the set of elementary neural network operations consists of one or more of:

   a convolutional operation;
   a pooling operation;
   an element-wise operation;
   an activation operation;
   a local response normalisation operation;
   a tensor rescale operation;
   a channel permutation operation;

a reshaping operation;
a concatenation;
reduction operations including sum, mean, minimise and maximise.

10. The method of any of claims 8 or 9, wherein said processing the received input image signal by performing the base image processing function refines the received input image signal in one regard.

11. The method according to claim 10, wherein said processing the received input image signal using the refinement function supplements the refinement performed by the base image processing function.

12. The method according to claim 11, wherein said processing the received input image signal using the refinement function supplements the refinement performed by the base image processing function such that said combining corrects an error in the processed image signal from performing the base image processing function.

13. The method according to any of claims 8 to 12, wherein a refinement of the image signal performed by processing the received input image signal using the refinement function is small in comparison to a refinement of the image signal performed by processing the received input image signal by performing the base image processing function.

14. The method according to any of claims 8 to 13, wherein the task of the functional block of the pipeline implemented by the module is any of demosaicing, sharpening, black-level subtraction, spatial denoising, global tone mapping, channel gain application, automatic white balance, or colour correction.

15. An integrated circuit definition dataset that, when processed in an integrated circuit manufacturing system, configures the integrated circuit manufacturing system to manufacture an inference device as claimed in claim 7.

**Figure 1**

**Figure 2**

EP 4 485 343 A1

S10 — Characterise an Image Capture Device (Camera)

S11 — Configure the Capture Model

S12 — Identify a training set of Images

S13 — Train the differentiable model ISP

S14 — Test the Trained ISP

S15 — Does the Trained ISP meet the user's requirements?

No

Yes

**Figure 3**

S111 — Receive one or more registered degraded and reference image pair

S112 — Inputting a degraded image signal to an ISP

S113 — Processing the degraded image signal

S114 — Calculating an error between the reference image and the first processed image signal

S115 — Updating the parameters of the first image processing function based on the error

S116

**Figure 4**

Figure 5

Figure 6

Figure 7

**Figure 8**

EP 4 485 343 A1

| Black Level Subtraction Module | | Channel Gains | | Denoiser | |
|---|---|---|---|---|---|
| Eltwise add | 901 | Eltwise multiply | 902 | Bilateral filter | 903 |

904

Demosaicing Module

920

| Bilinear filter | 905 |
|---|---|

921

| Conv2d Stride 2 10x10 | 906 | ReLU | 907 | Conv2d Stride 1 3x3 | 906 | ReLU | 907 | Conv2d Stride 1 3x3 | 906 | ReLU | 907 | Deconv2d Stride 2 5x5 | 906 | Eltwise add |
|---|---|---|---|---|---|---|---|---|---|---|---|---|---|---|

| Sharpening Module | | Colour correction Module | | Auto white balance | | | Gamma correction Module |
|---|---|---|---|---|---|---|---|
| conv2d | 908 | Conv2d Stride 1 1x1 | 909 / 906 | Grey-world White balance | 911 | Eltwise multiply | Local response normalisation |

910    912

**Figure 9**

Figure 10

**Figure 11**

**FIGURE 12**

**FIGURE 13**

EP 4 485 343 A1

$1/\sigma_r^2$

1401     1402     1403     1404     1405

(H',W',1)   | conv2d |   (H',W',K²)   | − |   | . |   | . |   | exp(-x) |   (H',W',K²)

1408     1409

| sum reduce |   (H',W',1)   | 1/x |   (H',W',1)

1406     1407     1410

| . |   (H',W',K²)   | sum reduce |   (H',W',1)   | . |   (H',W',1)

**Figure 14**

Europäisches
Patentamt

European
Patent Office

Office européen
des brevets

## EUROPEAN SEARCH REPORT

**Application Number**

EP 24 18 4973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/207656 A1 (YAO ANBANG [CN] ET AL) 30 June 2022 (2022-06-30) | 1-4, 6-11, 13-15 | INV. G06T1/20 |
| A | * the whole document * | 5,12 | |
| X | CHYUAN-TYNG WU ET AL: "VisionISP: Repurposing the Image Signal Processor for Computer Vision Applications", ARXIV.ORG, CORNELL UNIVERSITY LIBRARY, 201 OLIN LIBRARY CORNELL UNIVERSITY ITHACA, NY 14853, 14 November 2019 (2019-11-14), XP081532318, DOI: 10.1109/ICIP.2019.8803607 | 1-4, 6-11, 13-15 | |
| A | * the whole document * | 5,12 | |
| X | CN 114 429 207 A (ALIPAY HANGZHOU INFORMATION TECH LIMITED COMPANY) 3 May 2022 (2022-05-03) | 1-4, 6-11, 13-15 | |
| A | * the whole document * | 5,12 | |
| X | LI XIANGYANG ET AL: "Heterogeneous Convolutional Neural Networks for Visual Recognition", 27 November 2016 (2016-11-27), SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 262 - 274, XP047363499, ISBN: 978-3-540-74549-5 [retrieved on 2016-11-27] | 1-4, 6-11, 13-15 | **TECHNICAL FIELDS SEARCHED (IPC)** G06T G06N |
| A | * the whole document * | 5,12 | |
| A,D | WO 2022/193514 A1 (HUAWEI TECH CO LTD [CN]) 22 September 2022 (2022-09-22) * the whole document * | 1-15 | |

The present search report has been drawn up for all claims

| Place of search | Date of completion of the search | Examiner |
|---|---|---|
| Munich | 6 November 2024 | Celik, Hasan |

EPO FORM 1503 03.82 (P04C01)

## ANNEX TO THE EUROPEAN SEARCH REPORT
## ON EUROPEAN PATENT APPLICATION NO.

EP 24 18 4973

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2024

| Patent document cited in search report | | Publication date | Patent family member(s) | | Publication date |
|---|---|---|---|---|---|
| US 2022207656 | A1 | 30-06-2022 | CN | 114693850 A | 01-07-2022 |
| | | | US | 2022207656 A1 | 30-06-2022 |
| CN 114429207 | A | 03-05-2022 | NONE | | |
| WO 2022193514 | A1 | 22-09-2022 | US | 2022301123 A1 | 22-09-2022 |
| | | | WO | 2022193514 A1 | 22-09-2022 |

For more details about this annex : see Official Journal of the European Patent Office, No. 12/82

**EP 4 485 343 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2310032 A
- GB 2310035 A
- GB 30JUNE2023 A
- GB 2310033 A
- WO 2022193514 A1